# EUROPÄISCHE PATENTSCHRIFT

(11) **EP 4 006 567 B1**
(45) Veröffentlichungstag und Bekanntmachung des Hinweises auf die Patenterteilung: **01.03.2023**
(21) Anmeldenummer: 21208809.0
(22) Anmeldetag: 17.11.2021
(51) Int. Cl.: G01R 33/30, G01R 33/3815, G01R 33/62, G01R 33/44, G01R 33/3875

(54) **MAGNETSYSTEM ZUR DURCHFÜHRUNG VON 2-FELD-NMR-EXPERIMENTEN UND ZUGEHÖRIGES NACHRÜSTVERFAHREN**
MAGNET SYSTEM FOR CARRYING OUT 2-FIELD NMR EXPERIMENTS AND CORRESPONDING RETROFITTING METHOD
SYSTÈME MAGNÉTIQUE DESTINÉ À LA MISE EN OEUVRE DES EXPÉRIENCES RMN À 2 CHAMPS ET PROCÉDÉ DE MISE À NIVEAU ASSOCIÉ

(30) Priorität: 26.11.2020 DE 102020214887
(43) Veröffentlichungstag der Anmeldung: 01.06.2022
(73) Patentinhaber: Bruker Switzerland AG, 8117 Fällanden (CH)
(72) Erfinder: Günter, Kenneth J., 8002 Zürich (CH); Wüthrich, Thomas, 8606 Greifensee (CH); Baer, Alexander, 8050 Zürich (CH)
(74) Vertreter: Kohler Schmid Möbus Patentanwälte

(56) Entgegenhaltungen:
- EP-B1- 1 747 478
- US-A1- 2013 168 576

## Beschreibung

Die Erfindung betrifft ein Magnetsystem zur Durchführung von 2-Feld-NMR-Experimenten, umfassend
- einen supraleitenden Hauptfeldmagneten, geeignet zur Erzeugung eines ersten Magnetfelds in einem ersten Probenvolumen,
- einen supraleitenden Zusatzfeldmagneten, geeignet zur Erzeugung eines zweiten Magnetfelds in einem zweiten Probenvolumen, wobei das erste Magnetfeld stärker ist als das zweite Magnetfeld, und
- einen Kryostaten mit einem gekühlten Hauptspulenbehälter, der den Hauptfeldmagneten enthält, mit einer evakuierten Raumtemperatur(=RT)-Ummantelung, die den Hauptspulenbehälter enthält, und mit einer Raumtemperatur(=RT)-Bohrung, die durch den Hauptfeldmagneten und durch den Zusatzfeldmagneten verläuft und das erste Probenvolumen und das zweite Probenvolumen enthält.

Ein solches Magnetsystem ist aus der EP 1 747 478 B1 bekannt geworden.

Kernspinresonanz(=NMR)-Spektroskopie ist ein leistungsfähiges Verfahren der instrumentellen Analytik, mit dem die chemische Zusammensetzung von Proben untersucht werden kann. Dabei werden in die Probe Hochfrequenzsignale eingestrahlt, und die Probe strahlt daraufhin für ihre Zusammensetzung charakteristische Hochfrequenzsingale aus, die vermessen werden.

Eine Möglichkeit, die Messempfindlichkeit und Auflösung von NMR-Messungen zu erhöhen, ist die so genannte 2-Feld NMR-Spektroskopie. Die 2-Feld NMR-Spektroskopie wird beispielsweise erläutert in S. F. Cousin et al., Phys. Chem. Chem. Phys., 2016, 18, 33187. Ein 2-Feld NMR-Spektrometer besitzt zwei magnetische Zentren (Orte) mit unterschiedlicher statischer Magnetfeldstärke, an denen eine Probe mit Hochfrequenz-Pulsen beaufschlagt werden und/oder die Reaktion der Probe vermessen werden kann.

Bei einem typischen 2-Feld-NMR-Experiment wird die Probe zunächst an einem ersten Ort (erstes magnetisches Zentrum, erstes Probenvolumen) einem ersten, starken Magnetfeld ausgesetzt, sodann an einen zweiten Ort (zweites magnetisches Zentrum, zweites Probenvolumen) eines zweiten, weniger starken Magnetfelds verbracht, wobei dort Kernspins relaxiert und/oder manipuliert werden, und schließlich wird die Probe wieder an den Ort des ersten, starken Magnetfelds verbracht, wo die eigentliche NMR-Messung stattfindet. Am zweiten Ort kann die Polarisation auf einen gewünschten Atomkern übertragen werden, wodurch das NMR-Signal dieses Atomkerns in der nachfolgenden NMR-Messung verstärkt werden kann. Um die übertragene Polarisation beim Transport der Probe zwischen dem zweiten Ort und dem ersten Ort möglichst gut zu erhalten, sollte dieser Transport rasch erfolgen, wofür ein kurzer Weg zwischen dem zweiten Ort und dem ersten Ort gewünscht ist.

Der übliche Aufbau eines Magnetsystems eines 2-Feld-NMR-Spektrometers, wie er beispielsweise bei S. F. Cousin, aaO, verwendet wurde, weist einen supraleitenden Magneten (Magnetspule) in einem Kryostaten auf. Im magnetischen Zentrum des supraleitenden Magneten, das sich in der Raumtemperaturbohrung des Kryostaten befindet, ist das erste Probenvolumen (erstes magnetische Zentrum) ausgebildet. Das zweite Probenvolumen (zweites magnetisches Zentrum) liegt in der Raumtemperaturbohrung im Streufeld des supraleitenden Magneten, wobei mittels ferromagnetischen Shims lokal ein näherungsweise homogenes Magnetfeld erzeugt wird. Ähnliche Magnetsysteme sind aus der EP 2 146 215 B1 und der EP 3 081 954 B1 bekannt geworden.

Dieser Magnetaufbau kann mit einem Standard-NMR-System realisiert werden, indem die ferromagnetischen Shims in der Raumtemperaturbohrung installiert werden. Nachteilig an diesem Magnetaufbau ist es, dass die Feldstärke im zweiten Probenvolumen auf ca. 0,5 Tesla oder weniger begrenzt ist. Weiterhin ist die Feldstärke im zweiten Probenvolumen nicht frei einstellbar. Bei Anordnung der ferromagnetischen Shims in der Raumtemperaturbohrung wird zudem der Bauraum erheblich eingeschränkt.

Aus der EP 1 747 478 B1 ist es bekannt, in einem Kryostaten einen Hauptfeldmagneten anzuordnen, dessen magnetisches Zentrum das erste Probenvolumen (erstes magnetisches Zentrum) ausbildet, und weiterhin in dem Kryostaten einen Zusatzfeldmagneten anzuordnen, dessen magnetisches Zentrum das zweite Probenvolumen (zweites magnetisches Zentrum) ausbildet. Der Hauptfeldmagnet und der Zusatzfeldmagnet befinden sich übereinander in einem gemeinsamen Heliumbehälter. Dieser Magnetaufbau gestattet die freie Einstellung der Feldstärke im zweiten Probenvolumen, ist aber relativ teuer; das Magnetsystem ist hier speziell für die 2-Feld NMR ausgelegt. Ein Standard-NMR-System kann auf diesen Magnetaufbau nicht umgerüstet werden. Falls das Magnetfeld des Zusatzfeldmagneten gesweept werden soll, führt dies zu erhöhten Heliumverlusten im gemeinsamen Heliumtank durch Wärmeeintrag über die Stromzuleitungen, was ein Quenchrisiko für den Hauptfeldmagneten darstellt.

Aus der WO 02/37132 A1 ist es bekannt, ein DNP-Gerät separat von einem NMR-Spektrometer auszubilden, und das DNP-Gerät über eine Transferleitung mit einem NMR-Spektrometer zu verbinden (DNP=dynamic nuclear polarization). Das DNP-Gerät ist zur Magnetfelderzeugung mit einer supraleitenden Spule in einem eigenen Kryostaten ausgebildet, und neben einem Kryostaten des NMR-Spektrometers angeordnet. Bei dieser Anordnung kann ein Standard-NMR-System genutzt werden, jedoch ist der Weg zwischen dem Probenvolumen des DNP-Geräts und dem Probenvolumen des NMR-Spektrometers recht lang, was deutliche Verluste an Probenpolarisation verursachen kann.

Aus der US 9 279 868 B2 sind eine Apparatur und ein Verfahren für Rapid DNP bekannt geworden. Eine Probe ist zwischen zwei Positionen verfahrbar. Die eine Position ist in einem Hochfeld-Polarisationsmagneten eingerichtet, der einen eigenen Kryostaten hat. Die andere Position ist in einem Hilfs-Niederfeldmagneten eingerichtet, der oberhalb des besagten Kryostaten angeordnet ist.

### Aufgabe der Erfindung

Es ist Aufgabe der Erfindung, einen Magnetaufbau zur Verfügung zu stellen, mit dem auf kostengünstige Weise eine flexibel einsetzbare 2-Feld-NMR-Spektroskopie mit guter Signalstärke ermöglicht wird.

### Beschreibung der Erfindung

Diese Aufgabe wird erfindungsgemäß gelöst durch ein Magnetsystem der eingangs genannten Art, das dadurch gekennzeichnet ist,
dass das Magnetsystem einen gekühlten Zusatzspulenbehälter umfasst, der von einem Vakuum umgeben ist, der den Zusatzfeldmagneten enthält und der vom Hauptspulenbehälter beabstandet ist,
dass die RT-Ummantelung einen Flanschanschluss aufweist, wobei die RT-Bohrung durch eine Flanschöffnung des Flanschanschlusses verläuft,
dass der Zusatzspulenbehälter mit einem vorderen Ende durch die Flanschöffnung in die RT-Ummantelung hinein ragt, so dass auch der Zusatzfeldmagnet zumindest teilweise durch die Flanschöffnung in die RT-Ummantelung ragt,
und dass eine Verschlussstruktur vorhanden ist, welche am Flanschanschluss der RT-Ummantelung montiert ist, und welche die RT-Ummantelung zwischen Flanschanschluss und RT-Bohrung abdichtet.

Bei vielen Standard-NMR-Magnetsystemen ist der Kryostat bzw. dessen Raumtemperatur(=RT)-Ummantelung an einem axialen Ende der Raumtemperatur(=RT)-Bohrung mit einem Flanschanschluss (auch genannt Raumtemperatur-Flansch) ausgestattet, über den das Innere des Kryostaten bzw. der RT-Ummantelung zugänglich gemacht werden kann. Im Rahmen der vorliegenden Erfindung wird ein solcher Flanschanschluss genutzt, um einen Zusatzspulenbehälter, der den Zusatzfeldmagneten enthält, anzudocken. Dabei ragt der Zusatzspulenbehälter mit dem darin enthaltenen Zusatzfeldmagneten durch die Flanschöffnung in die RT-Ummantelung hinein, wodurch der Zusatzfeldmagnet bzw. das zweite Probenvolumen in dessen magnetischem Zentrum besonders nahe an das erste Probenvolumen heranrücken kann. Der Zusatzfeldmagnet nutzt also einen Teil des Innenraums des Kryostaten aus.

Das erste Probenvolumen befindet sich am Ort des magnetischen Zentrums des Hauptfeldmagneten, der im Hauptspulenbehälter im Kryostaten angeordnet ist. Ausgehend von einem Standard-NMR-Magnetsystem, in welchem nur ein Hauptfeldmagnet und ein erstes Probenvolumen mit einem ersten Magnetfeld eingerichtet sind, ist eine Nachrüstung mit dem Zusatzfeldmagneten zur Einrichtung des zweiten Probenvolumens leicht möglich, insbesondere unter Nutzung des Flanschanschlusses auch zur Befestigung des Zusatzspulenbehälters des Zusatzfeldmagneten, in der Regel indirekt über die Verschlussstruktur. Der Kryostat muss nicht oder allenfalls geringfügig angepasst werden, beispielsweise durch Austausch eines Wandrohrs der RT-Bohrung, wenn diese durchgängig eingerichtet werden soll.

Durch die Verschlussstruktur wird die RT-Ummantelung am Flanschanschluss abgedichtet, um das Vakuum im Inneren der RT-Ummantelung zur Isolation des Hauptspulenbehälters aufrecht erhalten zu können; insoweit ersetzt die Verschlussstruktur den bei einem Standard-NMR-Magnetsystem vorhanden Flanschdeckel. Man beachte, dass in die Verschlussstruktur andere Strukturen integriert sein können und dadurch diese anderen Strukturen (etwa ein Zusatzvakuumbehälter) an der Abdichtung zwischen Flanschanschluss und RT-Bohrung beteiligt sein können. Man beachte auch, dass die Abdichtung der Verschlussstruktur nicht unmittelbar gegenüber der Umgebung erfolgen muss, sondern beispielweise auch gegenüber einem Vakuum in einem Zusatzvakuumbehälter erfolgen kann.

Da das zweite Magnetfeld im zweiten Probenvolumen durch einen vom Hauptfeldmagneten separaten Zusatzfeldmagneten eingerichtet wird, kann das zweite Magnetfeld grundsätzlich beliebig und unabhängig vom ersten Magnetfeld gewählt werden, insbesondere auch mit einer Feldstärke größer als 0,5 Tesla. Üblicherweise ist das zweite Magnetfeld B2 deutlich kleiner als das erste Magnetfeld B1, bevorzugt mit B2≤0,33^{∗}B1, besonders bevorzugt mit B2≤0,25^{∗}B1, und ganz besonders bevorzugt B2≤0,20^{∗}B1. Man beachte, dass das erste Magnetfeld meist bei 10 Tesla oder mehr liegt, meist mit 10 T≤B1≤20 Tesla. Das zweite Magnetfeld B2 liegt meist bei 3 Tesla oder weniger, meist mit 0,5 T≤ B2≤ 3 T.

Zudem schränkt der Zusatzspulenbehälter den Bauraum innerhalb der RT-bohrung grundsätzlich nicht ein; typischerweise verläuft die RT-Bohrung mit konstantem Durchmesser im Bereich einschließlich und zwischen dem Hauptspulenbehälter und dem Zusatzspulenbehälter. Der Zusatzspulenbehälter umgreift die Raumtemperaturbohrung.

Der Flanschanschluss ist typischerweise bei einer vertikal ausgerichteten RT-Bohrung oben oder unten am Kryostaten ausgebildet. Der Flanschanschluss ist meist kreisrund ausgebildet.

Die voneinander separaten Hauptspulenbehälter und Zusatzspulenbehälter sind voneinander thermisch entkoppelt, insbesondere durch das Vakuum in der evakuierten RT-Ummantelung und das Vakuum, welches den Zusatzspulenbehälter umgibt. Wenn das Magnetfeld des Zusatzfeldmagneten gesweept werden soll, erhöht das nicht das Quenchrisiko des Hauptfeldmagneten. Der Hauptspulenbehälter und der Zusatzspulenbehälter sind typischerweise koaxial zur Achse der Raumtemperaturbohrung angeordnet, wobei der Hauptspulenbehälter und der Zusatzspulenbehälter bezüglich dieser Achse nebeneinander (also bei vertikaler Anordnung der Achse übereinander) und voneinander beabstandet angeordnet sind.

Das Vakuum, in welchem der Zusatzspulenbehälter angeordnet ist, ist bevorzugt mit dem Vakuum der evakuierten RT-Ummantelung verbunden. Alternativ kann auch das Vakuum, in welchem der Zusatzspulenbehälter angeordnet ist, von dem Vakuum der evakuierten RT-Ummantelung getrennt sein; in diesem Fall kann ein Zusatzvakuumbehälter eingesetzt werden, in welchem der Zusatzspulenbehälter angeordnet wird.

Der Hauptfeldmagnet und der Zusatzfeldmagnet sind bevorzugt elektrisch voneinander getrennt. Die Feldstärke des Zusatzfeldmagneten ist in der Regel über den elektrischen Strom in einer zugehörigen supraleitenden Magnetspule, welcher mit einem Netzgerät eingespeist wird, einstellbar, meist in einem Bereich von 0,5 T bis 3,0 T. Dabei kann vorgesehen sein, dass das Netzgerät den Stromfluss im Betrieb aufrechterhält (driven mode Betrieb), oder der Zusatzfeldmagnet weist einen supraleitenden Schalter auf, so dass im Betrieb ein persistenter elektrischer Strom fließt (persistent mode Betrieb).

Bevorzugt sind die Kühlung des Hauptspulenbehälters und die Kühlung des Zusatzspulenbehälters voneinander unabhängig. Der Hauptspulenbehälter enthält in der Regel flüssiges und/oder superflüssiges Helium zur Kühlung des Hauptfeldmagneten, ggf. kann ein Kryokühler (etwa einen Pulsrohrkühler) für eine He-Rückverflüssigung vorgesehen sein; alternativ kann auch eine kryogenfreie Kühlung des Hauptspulenbehälters bzw. des darin enthaltenen Hauptfeldmagneten mit einem Kryokühler vorgesehen sein. Der Zusatzspulenbehälter kann flüssiges und/oder superflüssiges Helium zur Kühlung enthalten; bevorzugt ist eine aktive, insbesondere kryogenfreie, Kühlung des Zusatzspulenbehälters bzw. des darin enthaltenen Zusatzfeldmagneten durch einen Kryokühler vorgesehen.

Der Zusatzspulenbehälter kann von einem eigenen, gekühlten Strahlungsschild umgeben sein; dieser Strahlungsschild kann beispielsweise mit flüssigem Stickstoff oder über die erste Kühlstufe eines Kryokühlers, der auch den Zusatzspulenbehälter mit einer oder mehreren weiteren Kühlstufen kühlt, gekühlt werden.

Am Ort des zweiten Probenvolumens wird eine Probe für eine NMR-Messung vorbereitet, und am Ort des ersten Probenvolumens wird anschließend die Probe der eigentlichen NMR-Messung unterzogen. Insbesondere ist es möglich, eine Probe zunächst im ersten Probenvolumen vorzupolarisieren, dann die Probe zum zweiten Probenvolumen zu verbringen und dort zu relaxieren und/oder einer Spin-Manipulation zu unterziehen, und schließlich wieder die Probe zum ersten Probenvolumen zu verbringen und dort der NMR-Messung zu unterziehen. Typischerweise werden zu diesem Zweck für eine Messung in der RT-Bohrung um das erste Probenvolumen und um das zweite Probenvolumen je ein NMR-Spulensystem (etwa umfassend Sende- und Lesespulen) angeordnet. Bevorzugt wird ein erfindungsgemäßes Magnetsystem für ein solches 2-Feld-NMR-Experiment verwendet.

Das Magnetsystem verfügt typischerweise über einen Transportmechanismus, mit dem eine Probe in der RT-Bohrung zwischen dem ersten Probenvolumen (im magnetischen Zentrum des Hauptfeldmagneten) und dem zweiten Probenvolumen (im magnetischen Zentrum des Zusatzfeldmagneten) bewegt werden kann. Der Transportmechanismus ist zumindest teilweise in der RT-Bohrung angeordnet.

In der Regel ist das erfindungsgemäße Magnetsystem so aufgebaut, dass die Variation des Streufelds des Zusatzfeldmagneten über eine axiale Länge von 1 cm im Zentrum des ersten Probenvolumens normiert auf die gesamte Magnetfeldstärke im ersten Probenvolumen 10 ppm oder kleiner ist, meist sogar 1 ppm oder kleiner. Umgekehrt ist in der Regel die Variation des Streufelds des Hauptfeldmagneten über eine axiale Länge von 1 cm im Zentrum des zweiten Probenvolumens normiert auf die gesamte Magnetfeldstärke im zweiten Probenvolumen im Bereich 10-50 ppm. Um die Streufelder zu minimieren, sind der Hauptfeldmagnet und der Zusatzfeldmagnet in der Regel aktiv abgeschirmt. Die Homogenität in den beiden Probenvolumina kann, falls erforderlich, mit Shimvorrichtungen verbessert werden. Die magnetische Kraft zwischen beiden Magneten (im Betrieb bei maximalem Betriebsstrom) beträgt typischerweise 500 N oder weniger, und meist 100 N oder weniger oder sogar 10 N oder weniger.

Die Magnetfelder werden im Allgemeinen hier bezüglich ihrer axialen Richtung (entlang der RT-Bohrung, B0-Richtung) betrachtet, insbesondere bezüglich ihrer Stärke und Homogenität.

### Bevorzugte Ausführungsformen

Bei einer bevorzugten Ausführungsform des erfindungsgemäßen Magnetsystems ist vorgesehen, dass das Magnetsystem einen geschlossenen, evakuierten Zusatzvakuumbehälter ausbildet, in welchem der Zusatzspulenbehälter angeordnet ist, und in welchem das Vakuum herrscht, in dem der Zusatzspulenbehälter angeordnet ist, so dass das Vakuum im Zusatzvakuumbehälter getrennt ist von einem Vakuum in der RT-Ummantelung. Dadurch kann die thermische Isolation zwischen Zusatzspulenbehälter und Hauptspulenbehälter verbessert werden, oder auch die Montage des Zusatzspulenbehälters vereinfacht werden.

Bevorzugt ist weiterhin eine Ausführungsform, die vorsieht, dass die Verschlussstruktur einen Einsetzabschnitt umfasst, welcher in die Flanschöffnung einragt und welcher gegenüber der RT-Ummantelung nach innen übersteht,
dass der Zusatzspulenbehälter mit einem vorderen Ende in den Einsetzabschnitt hinein ragt,
und dass die RT-Bohrung durch den Einsetzabschnitt verläuft. Durch den Einsetzabschnitt kann Raum im Inneren des Kryostaten bzw. dessen RT-Ummantelung abgetrennt werden, der dann für den Zusatzspulenbehälter genutzt werden kann, wobei das Vakuum in der RT-Ummantelung über den Einsetzabschnitt abgedichtet wird. Der Zusatzspulenbehälter kann zugänglich gemacht werden, ohne das Vakuum in der RT-Ummantelung zu brechen, beispielsweise für eine Reparatur. Der Einsetzabschnitt ist typischerweise topfförmig mit einem Durchbruch für die RT-Bohrung ausgebildet. Diese Ausführungsform mit Einsetzabschnitt kann insbesondere mit einem Zusatzvakuumbehälter kombiniert werden.

Bei einer vorteilhaften Ausführungsform ist vorgesehen,
dass das Magnetsystem einen Haubenabschnitt umfasst, welcher die Flanschöffnung übergreift und welcher gegenüber der RT-Ummantelung nach außen übersteht,
dass der Zusatzspulenbehälter mit einem hinteren Ende in den Haubenabschnitt hinein ragt,
und dass die RT-Bohrung durch den Haubenabschnitt verläuft.

Mittels des Haubenabschnitts kann ein Raum definiert werden, in welchem der Zusatzspulenbehälter untergebracht wird. Der Haubenabschnitt kann dazu genutzt werden, das Vakuum, in welchem der Zusatzspulenbehälter angeordnet wird, mit einzurichten. Die Verschlussstruktur kann den Haubenabschnitt umfassen. Der Haubenabschnitt ist typischerweise topfförmig mit einem Durchbruch für die RT-Bohrung ausgebildet. Die Ausführungsform mit Haubenabschnitt kann insbesondere mit Bauformen mit Zusatzvakuumbehälter und/oder Einsetzabschnitt kombiniert werden.

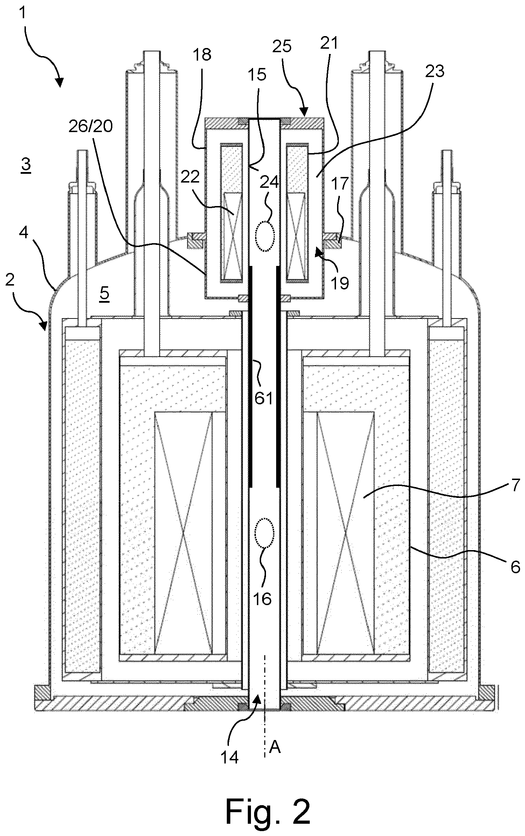

Bevorzugt ist eine Weiterbildung einer Ausführungsform mit Zusatzvakuumbehälter, Einsetzabschnitt und Haubenabschnitt, bei der der Zusatzvakuumbehälter durch die Wände des Haubenabschnitts, des Einsetzabschnitts und der RT-Bohrung begrenzt wird, wobei der Einsetzabschnitt das Vakuum in der RT-Ummantelung gegenüber dem Vakuum im Zusatzvakuumbehälter abdichtet. Diese Bauform ermöglicht in radialer Richtung viel Platz für den Zusatzspulenbehälter, und ermöglicht eine gute thermische Entkopplung von Hauptspulenbehälter und Zusatzspulenbehälter. Eine beispielhafte, entsprechende Bauform wird in Fig. 2 erläutert.

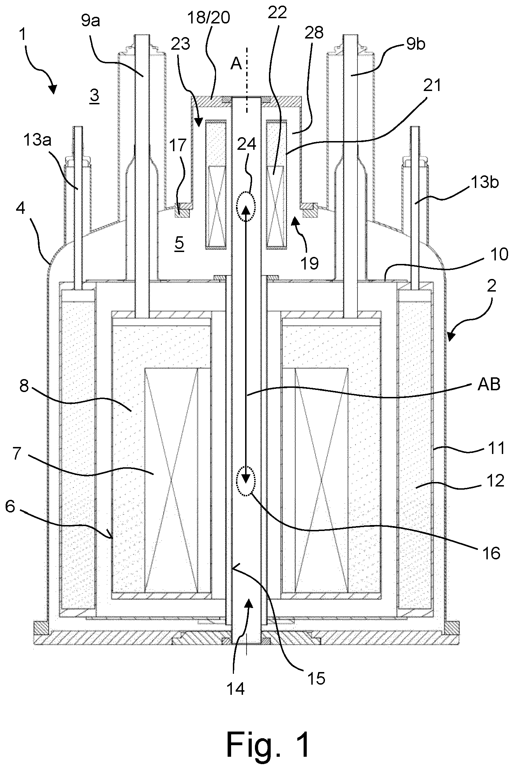

Bevorzugt ist auch eine Weiterbildung einer Ausführungsform mit einem Haubenabschnitt, die vorsieht, dass die Verschlussstruktur den Haubenabschnitt umfasst,
dass ein erster Spaltraum zwischen den Wänden des Zusatzspulenbehälters und des Haubenabschnitts zur RT-Ummantelung hin offen ausgebildet ist,
dass das Vakuum, in dem der Zusatzspulenbehälter angeordnet ist, und ein Vakuum in der RT-Ummantelung miteinander verbunden sind,
und dass der Haubenabschnitt das Vakuum in der RT-Ummantelung gegenüber der Umgebung abdichtet. Diese Bauform ist besonders einfach; der Zusatzspulenbehälter hat zudem in radialer Richtung viel Platz und kann in axialer Richtung sehr nah an den Hauptspulenbehälter heranrücken. Eine beispielhafte, entsprechende Bauform wird in Fig. 1 erläutert.

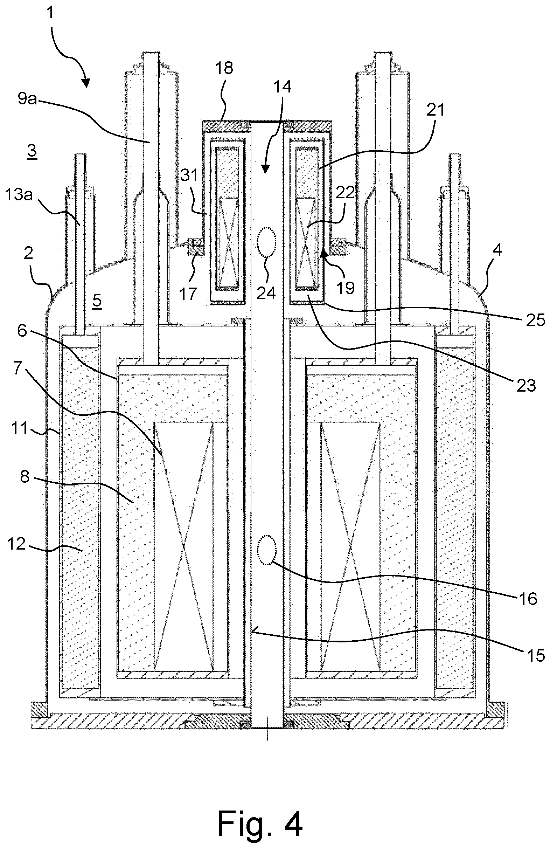

Vorteilhaft ist weiterhin eine Weiterbildung einer Ausführungsform mit Zusatzvakuumbehälter und Haubenabschnitt, die vorsieht,
dass die Verschlussstruktur den Haubenabschnitt umfasst,
dass der Zusatzvakuumbehälter mit einem hinteren Ende in den Haubenabschnitt hineinragt,
dass ein zweiter Spaltraum zwischen den Wänden des Haubenabschnitts und des Zusatzvakuumbehälters zur RT-Ummantelung hin offen ausgebildet ist,
und dass der Haubenabschnitt das Vakuum in der RT-Ummantelung gegenüber der Umgebung abdichtet. Diese Bauform ermöglicht eine besonders gute thermische Entkopplung des Zusatzspulenbehälters gegenüber dem Hauptspulenbehälter. Der Zusatzvakuumbehälter kann hier gleichzeitig auch als ein den Zusatzspulenbehälter vollständig umgebender Strahlungsschild dienen. Eine beispielhafte, entsprechende Bauform wird in Fig. 4 erläutert.

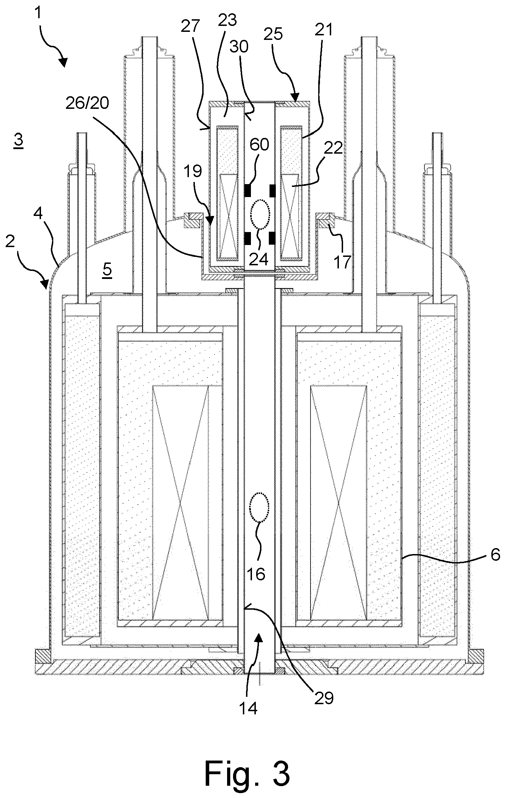

Bei einer bevorzugten Weiterbildung einer Ausführungsform mit Zusatzvakuumbehälter und Einsetzabschnitt ist vorgesehen, dass der Zusatzvakuumbehälter auf einer dem Hauptspulenbehälter abgewandten Seite des Einsetzabschnitts angeordnet ist,
dass der Zusatzvakuumbehälter durch eine vom Einsetzabschnitt separate Behälterwand und die RT-Bohrung begrenzt wird,
und dass der Einsetzabschnitt das Vakuum in der RT-Ummantelung gegenüber der Umgebung abdichtet. Diese Bauform ist besonders einfach. Der Zusatzvakuumbehälter kann als eigene Baugruppe ohne Berührung zum Vakuum der RT-Ummantelung gehandhabt werden. Dadurch kann auch die Ausrichtung des Zusatzfeldmagneten vereinfacht werden. Zudem ist ein Austausch oder eine Reparatur des Zusatzvakuumbehälters oder auch der darin enthaltenen Bauteile besonders einfach möglich, insbesondere ohne dass der Hauptfeldmagnet entladen werden muss. Eine beispielhafte, entsprechende Bauform wird in Fig. 3 erläutert.

Vorteilhaft ist eine Weiterentwicklung dieser Weiterbildung, bei der die Wand der RT-Bohrung mehrteilig ausgebildet ist, wobei ein erstes Teilstück der Wand der RT-Bohrung die RT-Ummantelung bis zum Einsetzabschnitt begrenzt, und wobei ein zweites Teilstück der Wand der RT-Bohrung den Zusatzvakuumbehälter begrenzt. Dadurch werden die Installation und nötigenfalls Deinstallation sowie die Ausrichtung des Zusatzvakuumbehälters und der darin enthaltenen Bauteile, insbesondere des Zusatzspulenbehälters samt des Zusatzfeldmagneten, weiter vereinfacht.

Bei einer bevorzugten Ausführungsform ist die Wand der RT-Bohrung einteilig ausgebildet. Dies vereinfacht bei vielen Bauformen die Abdichtung der RT-Bohrung gegenüber dem Vakuum in der RT-Ummantelung und/oder dem Vakuum, in dem der Zusatzspulenbehälter angeordnet ist.

Bevorzugt ist eine Ausführungsform, bei der der Kryostat mit einem gekühlten Zwischenbehälter ausgebildet ist, der in der evakuierten RT-Ummantelung angeordnet ist, wobei der Hauptspulenbehälter im Zwischenbehälter angeordnet ist, insbesondere wobei der Zwischenbehälter mit flüssigem Stickstoff gekühlt ist. Dadurch kann die thermische Isolation des Hauptspulenbehälters gegenüber der Umgebung bzw. dessen Kühlung auf tiefkalte Temperaturen von 4,2 K oder weniger vereinfacht werden.

Besonders vorteilhat ist eine Ausführungsform, bei der der Zusatzspulenbehälter einen maximalen Außendurchmesser DZSB quer zur RT-Bohrung aufweist, der kleiner ist als der minimale Innendurchmesser MID der Flanschöffnung, insbesondere wobei alle durch die Flanschöffnung in die RT-Ummantelung einragenden Bauteile einen maximalen Außendurchmesser DALL quer zur RT-Bohrung aufweisen, der kleiner ist als der minimale Innendurchmesser MID der Flanschöffnung. Dadurch wird der Einbau des Zusatzspulenbehälters, oder aller einragenden Bauteile, vereinfacht, denn der Zusatzspulenbehälter oder die einragenden Bauteile können einfach axial durch die Flanschöffnung in den Kryostaten eingefahren werden. Falls es einen Zusatzvakuumbehälter gibt, gilt für dessen maximalen Außendurchmesser DZVB bevorzugt auch DZVB < MID. Alternativ ist es auch möglich, den Zusatzspulenbehälter oder einragende Bauteile beim Einbau einzuschwenken oder zu zerlegen und erst im einragenden Zustand zusammenzubauen.

Vorteilhaft ist weiterhin eine Ausführungsform, bei der ein Shimsystem zur Homogenisierung des Magnetfelds im zweiten Probenvolumen vorhanden ist. Mit dem Shimsystem kann die Homogenität im zweiten Probenvolumen verbessert werden, entsprechend den Anforderungen eines vorgesehenen Polarisierungsprozesses. Bevorzugt ist ein aktives (elektrisches) Shimsystem vorgesehen. Das Shimsystem kann innerhalb der Raumtemperaturbohrung oder auch außerhalb der Raumtemperaturbohrung angeordnet sein, insbesondere auch außen auf der Wandung der Raumtemperaturbohrung aufsitzend, oder auch angeordnet am oder im Zusatzspulenbehälter.

Besonders bevorzugt ist eine Ausführungsform, die vorsieht, dass die RT-Bohrung in einem Bereich zwischen dem ersten Probenvolumen und dem zweiten Probenvolumen durch einen magnetischen Tunnel führt oder einen magnetischen Tunnel enthält, sodass im Betrieb das Magnetfeld entlang eines Probentransportwegs in der RT-Bohrung zwischen dem ersten Probenvolumen und dem zweiten Probenvolumen überall wenigstens 0,1 T, bevorzugt wenigstens 0,5 T, beträgt. Mittels des magnetischen Tunnels können Polarisationsverluste bei einer Probe während des Transports vom zweiten Probenvolumen zum ersten Probenvolumen reduziert werden. Der magnetische Tunnel umfasst typischerweise einen Satz von Permanentmagneten und/oder einen Satz von Magnetspulen, die typischerweise radial außen oder innen an der Wand der RT-Bohrung angeordnet sind.

Besonders bevorzugt ist eine Ausführungsform, bei der das erste Probenvolumen und das zweite Probenvolumen einen Abstand AB aufweisen,
mit 0,6 m ≤ AB ≤ 1,3 m. Solch kleine Abstände können mit der vorliegenden Erfindung mit geringem Aufwand eingerichtet werden, wodurch Polarisationsverluste beim Transport einer Probe vom zweiten zum ersten Probenvolumen minimiert werden können. Im Allgemeinen ist bevorzugt AB ≤ 1,2 m, besonders bevorzugt AB ≤ 1,0 m. Der Abstand AB wird in axialer Richtung (entlang der RT-Bohrung) gemessen.

Besonders bevorzugt ist eine Ausführungsform, bei der der Hauptfeldmagnet und der Zusatzfeldmagnet elektrisch voneinander getrennt sind. Dadurch ist eine separate Einstellung der Feldstärken von erstem und zweitem Magnetfeld besonders einfach möglich, und ein plötzlicher Verlust der Supraleitung (Quench) in einem der beiden Magnete hat keine direkte Auswirkung auf den anderen Magneten.

### Erfindungsgemäße Nachrüstverfahren

In den Rahmen der vorliegenden Erfindung fällt auch ein Verfahren zur Nachrüstung eines Magnetsystems für 2-Feld-NMR-Experimente, insbesondere um ein erfindungsgemäßes, oben beschriebenes Magnetsystem zu erhalten, mit folgenden Schritten:
a) Bereitstellen eines Magnetsystems umfassend einen supraleitenden Hauptfeldmagneten, geeignet zur Erzeugung eines ersten Magnetfelds in einem ersten Probenvolumen, und einen Kryostaten mit einem kühlbaren Hauptspulenbehälter, der den Hauptfeldmagneten enthält, mit einer evakuierbaren Raumtemperatur(=RT)-Ummantelung, die den Hauptspulenbehälter enthält, und mit einer Raumtemperatur(=RT)-Bohrung, die durch den Hauptfeldmagneten verläuft und das erste Probenvolumen enthält, wobei die RT-Ummantelung einen Flanschanschluss aufweist, dessen Flanschöffnung mit einem Flanschdeckel verschlossen ist, wobei die RT-Bohrung durch die Flanschöffnung und den Flanschdeckel verläuft;
b) Entfernen des Flanschdeckels vom Flanschanschluss;
c) Montieren eines Zusatzspulenbehälters, der im montierten Zustand kühlbar
   und mit einem Vakuum umgebbar ist, und der einen supraleitenden Zusatzfeldmagneten enthält,
   und Montieren einer Verschlussstruktur, welche die RT-Ummantelung zwischen Flanschanschluss und RT-Bohrung abdichtet, am Flanschanschluss der RT-Ummantelung,
   wobei der Zusatzspulenbehälter mit einem vorderen Ende durch die Flanschöffnung in die RT-Ummantelung hinein ragt, so dass der Zusatzfeldmagnet zumindest teilweise durch die Flanschöffnung in die RT-Ummantelung ragt,
   wobei der Zusatzfeldmagnet geeignet ist zur Erzeugung eines zweiten Magnetfelds in einem zweiten Probenvolumen, wobei das erste Magnetfeld stärker ist als das zweite Magnetfeld, und wobei die RT-Bohrung auch durch den Zusatzfeldmagneten verläuft und das zweite Probenvolumen enthält. Mit dem erfindungsgemäßen Verfahren ist es möglich, ein Standard-NMR-Magnetsystem, das lediglich mit einem Hauptfeldmagneten für ein erstes Probenvolumen ausgestattet ist und einen axialen Flanschanschluss aufweist, auf einfache und kostengünstige Weise für 2-Feld-NMR-Messungen zu ertüchtigen. Dadurch, dass der Zusatzspulenbehälter durch die Flanschöffnung hindurch in die RT-Ummantelung des Kryostaten hinein ragt, kann der axiale Abstand zwischen dem ersten Probenvolumen im magnetischen Zentrum des Hauptfeldmagneten und dem zweiten Probenvolumen im magnetischen Zentrum des Zusatzfeldmagneten gering gehalten werden. Der Zusatzfeldmagnet ist vom Hauptfeldmagnet räumlich getrennt, so dass keine oder allenfalls geringe thermische Kopplung besteht. Über den Zusatzfeldmagneten kann das Magnetfeld im zweiten Probenvolumen für den Anwendungsfall spezifisch eingestellt werden.

Bevorzugt ist eine Variante des erfindungsgemäßen Verfahrens, bei dem während Schritt c) der Zusatzspulenbehälter fest mit der Verschlussstruktur verbunden ist,
insbesondere wobei während Schritt c) alle durch die Flanschöffnung in die RT-Ummantelung einragenden Bauteile fest mit der Verschlussstruktur verbunden sind. Dadurch wird die Montage des Magnetsystems erleichtert. Im Wesentlichen braucht nur eine Baugruppe ausgerichtet und befestigt zu werden.

Bei einer bevorzugten Variante wird nach Schritt a) ein vorhandenes, einteiliges Wandrohr der RT-Bohrung des Kryostaten durch ein axial längeres, einteiliges Wandrohr ersetzt. Das längere Wandrohr kann dann auch durch den Zusatzspulenbehälter reichen. Dadurch kann bei vielen Bauformen des Magnetsystems auf einfache Weise eine hohe Dichtigkeit der RT-Bohrung erreicht werden.

Bei einer alternativen, vorteilhaften Variante ist vorgesehen, dass nach Schritt a) ein vorhandenes, einteiliges Wandrohr der RT-Bohrung des Kryostaten gekürzt oder durch ein kürzeres Wandrohr ersetzt wird, so dass im Kryostaten ein erstes Teilstück einer Wand der RT-Bohrung angeordnet ist, welches zumindest den Hauptspulenbehälter durchragt, und weiterhin ein zweites Teilstück einer Wand der RT-Bohrung montiert wird, welches zumindest den Zusatzspulenbehälter durch ragt,
insbesondere wobei das zweite Teilstück während Schritt c) zusammen mit dem Zusatzspulenbehälter montiert wird. Durch eine zweiteilige Wand der RT-Bohrung kann die Montage und Ausrichtung des Zusatzspulenbehälters und des Zusatzfeldmagneten und allgemein die Handhabung einer zugehörigen Baugruppe vereinfacht werden.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden, sofern der definierte Schutzumfang der Erfindung nicht verlassen wird. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

- Fig. 1: zeigt einen schematischen Längsschnitt durch eine erste Ausführungsform eines erfindungsgemäßen Magnetsystems, mit einem Haubenabschnitt, der zur RT-Ummantelung des Kryostaten offen ist, und einem einheitlichen Vakuumraum;
- Fig. 2: zeigt einen schematischen Längsschnitt durch eine zweite Ausführungsform eines erfindungsgemäßen Magnetsystems, mit einem Haubenabschnitt und einem Einsetzabschnitt, die zusammen einen Zusatzvakuumbehälter ausbilden;
- Fig. 3: zeigt einen schematischen Längsschnitt durch eine dritte Ausführungsform eines erfindungsgemäßen Magnetsystems, mit einem Einsetzabschnitt und einem Zusatzvakuumbehälter außerhalb des Vakuums der RT-Ummantelung;
- Fig. 4: zeigt einen schematischen Längsschnitt durch eine vierte Ausführungsform eines erfindungsgemäßen Magnetsystems, mit einem Haubenabschnitt und einem Zusatzvakuumbehälter, der im Vakuum der RT-Ummantelung angeordnet ist;
- Fig. 5a-f: zeigt schematisch den Ablauf eines erfindungsgemäßen Nachrüstverfahrens in einer ersten Variante, mit den Teilbildern

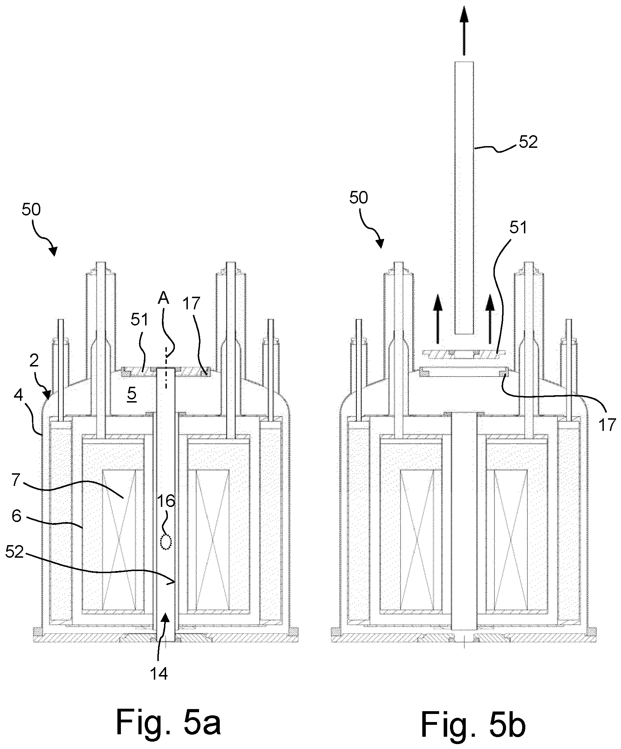

Fig. 5a nachzurüstendes Magnetsystem;
Fig. 5b Entfernen des Flanschdeckels und des alten Wandrohrs;

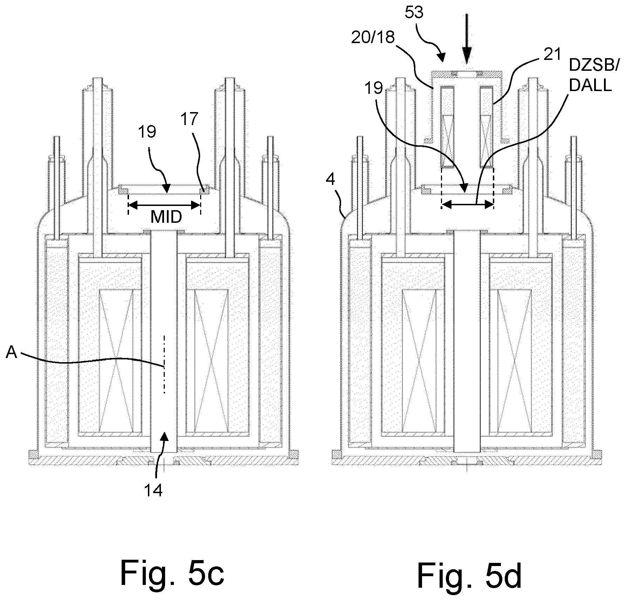

Fig. 5c offenes Magnetsystem;
Fig. 5d Montieren von Zusatzspulenbehälter und Haubenabschnitt;

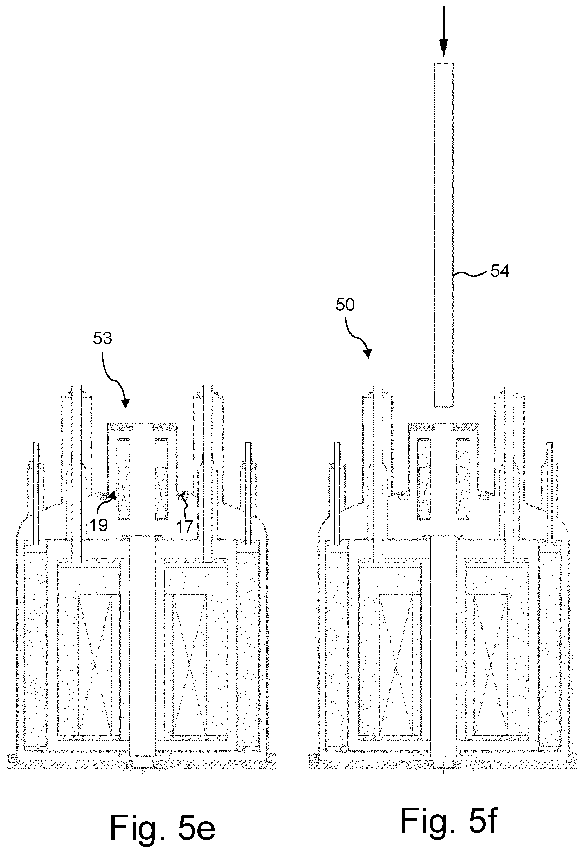

Fig. 5e teilmontiertes Magnetsystem;
Fig. 5f Montieren eines neuen, längeren Wandrohrs;

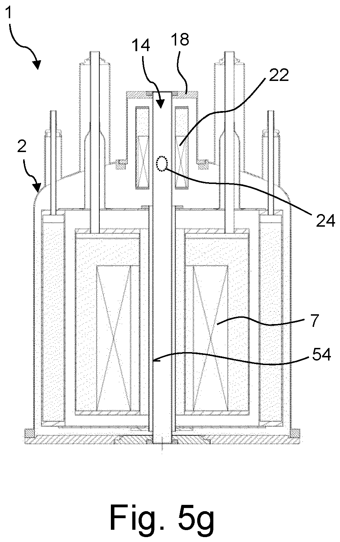

Fig. 5g nachgerüstetes Magnetsystem;

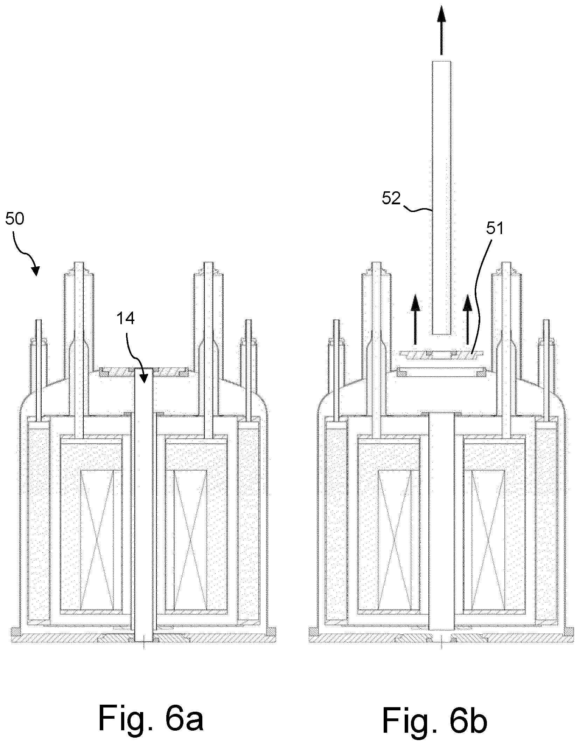

- Fig. 6a-f: zeigt schematisch den Ablauf eines erfindungsgemäßen Nachrüstverfahrens in einer zweiten Variante, mit den Teilbildern
Fig. 6a nachzurüstendes Magnetsystem;
Fig. 6b Entfernen des Flanschdeckels und des alten Wandrohrs;

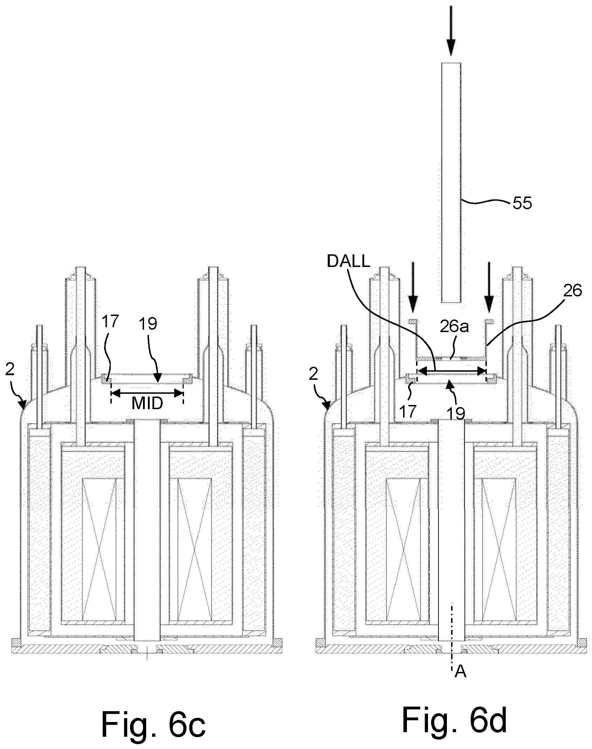

Fig. 6c offenes Magnetsystem;
Fig. 6d Montieren von Einsetzabschnitt und kürzerem Wandrohr;

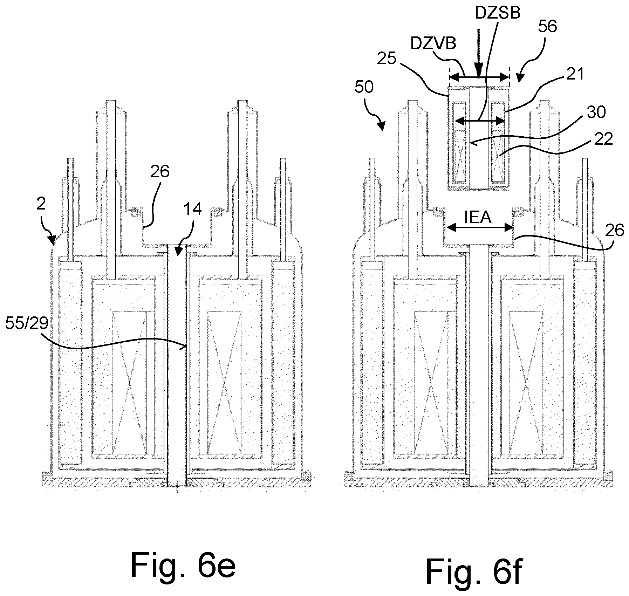

Fig. 6e teilmontiertes Magnetsystem;
Fig. 6f Montieren des Zusatzvakuumbehälters mit Zusatzspulenbehälter;

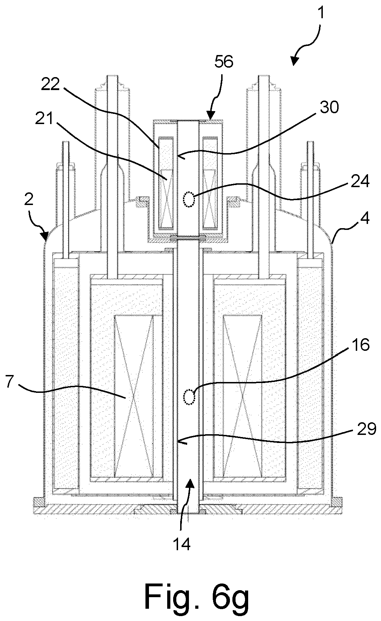

Fig. 6g nachgerüstetes Magnetsystem.

Die **Fig. 1** zeigt eine schematische Darstellung eines erfindungsgemäßen Magnetsystems, auf welchem 2-Feld-NMR-Experimente durchgeführt werden können, in einer ersten Ausführungsform im Längsschnitt.

Das Magnetsystem 1 ist mit einem Kryostaten 2 ausgebildet, welcher nach außen zur Umgebung 3 hin durch eine Raumtemperatur(=RT)-Ummantelung 4 begrenzt ist. Zudem durchzieht den Kryostaten 2 eine Raumtemperaturbohrung 14, die entlang einer hier vertikalen Achse A ausgerichtet ist; der Längsschnitt der Fig. 1 ist entlang dieser Achse A gewählt. Die RT-Bohrung 14 wird in der gezeigten Bauform durch ein durchgängiges (einstückiges) Wandrohr 15 begrenzt.

Im Inneren der RT-Ummantelung 4 herrscht ein Vakuum 5. Der Kryostat 2 enthält in diesem Vakuum 5 einen Hauptspulenbehälter 6, in welchem ein supraleitender Hauptfeldmagnet 7 in Form eines supraleitenden Spulensystems angeordnet ist. Im Hauptspulenbehälter 6 befindet sich zudem zur Kühlung des Hauptfeldmagneten 7 weiterhin flüssiges Helium 8.

Der Hauptspulenbehälter 6 kann in der gezeigten Ausführungsform über die Halsrohre 9a, 9b erreicht werden, etwa zum Nachfüllen mit flüssigem Helium. Zudem ist der Hauptspulenbehälter 6 hier in einem mit Stickstoff gekühlten Zwischenbehälter 10 angeordnet, an dessen radialer Außenseite ein Tank 11 für flüssigen Stickstoff 12 ausgebildet ist. Über die Halsrohre 13a, 13b kann der Tank 11 erreicht werden, etwa zum Nachfüllen von flüssigem Stickstoff. Im Inneren des Zwischenbehälters 10 herrscht bei der gezeigten Bauform das gleiche Vakuum 5 wie im übrigen Innenraum der RT-Ummantelung 4; der Zwischenbehälter 10 ist also nicht gasdicht ausgebildet, sondern dient vor allem als gekühlter Strahlungsschild.

Der Hauptfeldmagnet 7 erzeugt im Betrieb in einem ersten Probenvolumen 16 an seinem magnetischen Zentrum (erstes magnetisches Zentrum des Magnetsystems 1) ein erstes Magnetfeld von hoher Feldstärke B1, meist 10 Tesla oder mehr, und hoher Homogenität, mit einer relativen Feldstärkenvariation von meist 10 ppm oder kleiner über eine axiale Länge von 1 cm.

Die RT-Ummantelung 4 des Kryostaten 2 ist an einem hier oberen axialen Ende mit einem Flanschanschluss 17 ausgebildet, an welchem hier ein Haubenabschnitt 18 montiert ist. Der Haubenabschnitt 18 dichtet die RT-Ummantelung 4 zwischen dem Flanschanschluss 17 und der RT-Bohrung 14 ab, hier gegenüber der Umgebung 3. Der Haubenabschnitt 18 stellt daher hier eine Verschlussstruktur 20 dar, die am Flanschanschluss 17 montiert ist. Der Haubenabschnitt 18 ist im Wesentlichen topfförmig ausgebildet und steht gegenüber der RT-Ummantelung 4 nach außen (hier axial nach oben) über.

Der Haubenabschnitt 18 übergreifet einen Zusatzspulenbehälter 21, in welchem ein supraleitender Zusatzfeldmagnet 22 angeordnet ist. Dieser Zusatzspulenbehälter 21 wird in nicht näher dargestellter Weise gekühlt, beispielsweise durch einen Pulsrohrkühler. Falls gewünscht, kann der Zusatzspulenbehälter 21 von einem eigenen, gekühlten Strahlungsschild umgeben sein (nicht näher dargestellt).

Der Zusatzfeldmagnet 22 umfasst ein supraleitendes Spulensystem. Mit dem Zusatzfeldmagneten 22 kann im Betrieb in einem zweiten Probenvolumen 24 am magnetischen Zentrum des Zusatzfeldmagneten 22 (zweites magnetisches Zentrum des Magnetsystems 1) ein zweites Magnetfeld erzeugt werden. Das zweite Magnetfeld hat dabei eine kleinere Feldstärke B2 als das erste Magnetfeld. Meist beträgt die Feldstärke B2 des zweiten Magnetfelds zwischen 0,5 T und 3,0 Tesla. Das zweite Magnetfeld braucht in den meisten Anwendungsfällen nicht ganz so homogen zu sein wie das erste Magnetfeld; meist liegt die Homogenität des zweiten Magnetfelds bei 10-50 ppm über eine axiale Länge von 1 cm.

Der Zusatzspulenbehälter 21 ist von einem Vakuum 23 umgeben. Ein evakuierter, erster Spaltraum 28 zwischen dem Haubenabschnitt 18 und dem Zusatzspulenbehälter 21 ist zur RT-Ummantelung hin (in Fig. 1 nach unten hin, zur Flanschöffnung 19 hin) offen ausgebildet, so dass das Vakuum 5 in der RT-Ummantelung 4 und das Vakuum 23, das den Zusatzspulenbehälter 21 im Bereich des ersten Spaltraums 28 umgibt, miteinander verbunden sind und somit einen gemeinsamen Vakuumraum ausbilden.

Der Zusatzspulenbehälter 21 ragt mit einem vorderen (unteren) Ende durch die Flanschöffnung 19 des Flanschanschlusses 17 in die RT-Ummantelung 4 hinein, und ebenfalls ragt der Zusatzfeldmagnet 22 durch die Flanschöffnung 19 in die RT-Ummantelung 4 hinein. Dadurch wird für die Anordnung des Zusatzspulenbehälters 21 und des Zusatzfeldmagneten 22 teilweise Bauraum in Inneren der RT-Ummantelung 4 des Kryostaten 2 genutzt. Ein hinteres (oberes) Ende des Zusatzspulenbehälters 21 ragt in den Haubenabschnitt 18 hinein.

Die RT-Bohrung 14 durchragt den Hauptspulenbehälter 6, den Zusatzspulenbehälter 21, die Flanschöffnung 19 und den Haubenabschnitt 18. Die Probenvolumina 16, 24 liegen in der RT-Bohrung 14 mit einem (axialen) Abstand AB, der bevorzugt 1,3 m oder weniger beträgt, beispielsweise ca. 1,0 m beträgt (gemessen Zentrum zu Zentrum). Mit einem nicht näher dargestellten Transportmechanismus kann eine zu vermessende Probe zwischen dem ersten Probenvolumen 16 und dem zweiten Probenvolumen 24 und zurück transferiert werden, und bevorzugt auch in die RT-Bohrung 14 hinein und wieder hinaus. Für die Spin-Manipulationen und Messungen können nicht näher dargestellte NMR-Probenköpfe von außen (typischerweise von beiden axialen Enden her) in die RT-Bohrung 14 bis zu den Probenvolumina 16, 24 hineinragen.

In der Bauform von Fig. 1 kann der Zusatzfeldmagnet 22 besonders nahe an den Hauptfeldmagneten 7 heranrücken, so dass beim Transport einer Probe zwischen den Probenvolumina 24, 16 ein Polarisationsverlust minimiert werden kann. Weiterhin steht viel radialer Bauraum für den Zusatzspulenbehälter 21 zur Verfügung. Zudem muss nur ein Vakuumraum unterhalten werden.

Bezüglich der Ausführungsformen von Fig. 2 bis Fig. 4, die weitgehend der Bauform von Fig. 1 entsprechen, werden nachfolgend nur die wesentlichen Unterschiede zur Bauform von Fig. 1 erläutert

In der in **Fig. 2** gezeigten, zweiten Ausführungsform eines erfindungsgemäßen Magnetsystems 1 ist der Zusatzspulenbehälter 21 in einem Zusatzvakuumbehälter 25 angeordnet, in welchem das Vakuum 23 eingerichtet ist, welches den Zusatzspulenbehälter 21 umgibt. Der Zusatzvakuumbehälter 25 wird durch einen Einsetzabschnitt 26, einen Haubenabschnitt 18 und die RT-Bohrung 14 bzw. dessen Wandrohr 15 begrenzt.

Der Einsetzabschnitt 26 ragt dabei durch die Flanschöffnung 19 in die RT-Ummantelung 4 des Kryostaten 2 hinein, und dichtet die RT-Ummantelung 4 (bzw. das Vakuum 5 in ihrem Inneren) zwischen dem Flanschanschluss 17 und der RT-Bohrung 14 ab. Der Einsetzabschnitt 26 bildet daher hier eine Verschlussstruktur 20 für die RT-Ummantelung aus. Der Einsetzabschnitt 26 ist hier näherungsweise topfförmig ausgebildet, mit einem Durchbruch für die RT-Bohrung 14.

Hier einstückig verbunden mit dem Einsetzabschnitt 26 ist der Haubenabschnitt 18, der nach außen gegenüber der RT-Ummantelung 4 übersteht, hier nach axial oben. Der Haubenabschnitt 18 übergreift die Flanschöffnung 19 und den Zusatzspulenbehälter 21, und dichtet den Zusatzvakuumbehälter 25 gegenüber der Umgebung 3 ab. Der Zusatzvakuumbehälter 25 ist außenseitlich im Bereich des Übergangs von Einsetzabschnitt 26 und Haubenabschnitt 18 am Flanschanschluss 17 montiert.

Der Zusatzspulenbehälter 21 ragt mit einem vorderen (unteren) Ende durch die Flanschöffnung 19 in den Einsetzabschnitt 26 und in den axialen Bereich der RT-Ummantelung 4 ein; ebenso ragt mit einem vorderen (unteren) Ende der Zusatzfeldmagnet 22 durch die Flanschöffnung 19 in den Einsetzabschnitt 26 und in den axialen Bereich der RT-Ummantelung 4 ein.

In der Bauform von Fig. 2 ist für den Transportweg einer Probe zwischen dem ersten Probenvolumen 16 und dem zweiten Probenvolumen 24 ein magnetischer Tunnel 61 eingerichtet, der hier an der Innenseite der Wand der RT-Bohrung 14 ausgebildet ist. Der magnetische Tunnel 61 stellt sicher, dass über den besagten Transportweg die Probe stets einem Magnetfeld einer gewissen Mindeststärke ausgesetzt bleibt, beispielsweise wenigstens 0,1 Tesla. Dadurch können Polarisationsverluste beim Probentransport minimiert werden. Der magnetische Tunnel 61 umfasst hier eine permanentmagnetische Struktur, die entlang der Achse A (Achse der RT-Bohrung 14, gleichzeitig Richtung der vom Hauptfeldmagneten 7 und vom Zusatzfeldmagneten 22 erzeugten Magnetfelder) ausgerichtet ist.

In der gezeigten Ausführungsform sind das Vakuum 5 der RT-Ummantelung 4 und das Vakuum 23, in welchem der Zusatzspulenbehälter 21 angeordnet ist, durch den Einsetzabschnitt 26 voneinander getrennt, wodurch eine besonders gute thermische Isolation von Hauptspulenbehälter 6 und Zusatzspulenbehälter 21 erreicht wird. Ebenso steht viel radialer Bauraum für den Zusatzspulenbehälter 21 und den Zusatzfeldmagneten 22 zur Verfügung.

Beim Magnetsystem 1 gemäß der dritten Ausführungsform von **Fig. 3** ist ebenfalls ein Zusatzvakuumbehälter 25 für den Zusatzspulenbehälter 21 eingerichtet. Der Zusatzvakuumbehälter 25 wird dabei von einer eigenen Behälterwand 27 und der RT-Bohrung 14 begrenzt und dadurch gegenüber der Umgebung 3 abgedichtet.

Die RT-Ummantelung 4 wird mittels eines Einsetzabschnitts 26, der durch die Flanschöffnung 19 in die RT-Ummantelung 4 hineinragt, zwischen dem Flanschanschluss 17 und der RT-Bohrung 14 gegenüber der Umgebung 3 abgedichtet. Der Einsetzabschnitt 26 stellt daher eine Verschlussstruktur 20 der RT-Ummantelung 4 dar. Der Einsetzabschnitt 26 ist am Flanschanschluss 17 montiert.

Der Zusatzvakuumbehälter 25 ist vollständig auf einer dem Hauptspulenbehälter 6 abgewandten Seite des Einsetzabschnitts 26 angeordnet. Der Zusatzvakuumbehälter 25 ragt mit einem vorderen (unteren) Ende durch die Flanschöffnung 19 von hinten (oben) in den Einsetzabschnitt 26 hinein, und damit auch in den axialen Bereich der RT-Ummantelung 4 des Kryostaten 2 hinein. Der im Inneren des Vakuumzusatzbehälters 25 angeordnete Zusatzspulenbehälter 21 ragt ebenfalls mit einem vorderen (unteren) Ende durch die Flanschöffnung 19 in den Einsetzabschnitt 26 und damit in den axialen Bereich der RT-Ummantelung 4 hinein. Ebenso ragt der Zusatzfeldmagnet 22 mit einem vorderen (unteren) Ende durch die Flanschöffnung 19 in den Einsetzabschnitt 26 und in den axialen Bereich der RT-Ummantelung 4 hinein. Der Einsetzabschnitt 26, der hier näherungsweise topfförmig ausgebildet ist, eröffnet Bauraum für den Zusatzvakuumbehälter 25 bzw. den Zusatzspulenbehälter 21 und den Zusatzfeldmagneten 22 im Inneren der RT-Ummantelung 4, so dass das zweite Probenvolumen 24 nahe zum ersten Probenvolumen 16 angeordnet werden kann. Weiterhin steht ein hinteres Ende des Zusatzvakuumbehälters 25 gegenüber der RT-Ummantelung 4 des Kryostaten 2 nach außen hin (hier nach axial oben) über.

Die RT-Bohrung 14 ist hier nicht mit einem durchgängigen Wandrohr ausgebildet, sondern zweiteilig. Ein unteres, erstes Teilstück 29 der Wand der RT-Bohrung 14 begrenzt die RT-Bohrung 14 im Bereich der RT-Ummantelung 4 bis zum Einsetzabschnitt 26. Ein oberes Teilstück 30 der Wand der RT-Bohrung 14 begrenzt die RT-Bohrung 14 im Bereich des Zusatzvakuumbehälters 25.

Das Magnetsystem 1 umfasst hier auch ein Shimsystem 60 zur Homogenisierung des zweiten Magnetfelds im zweiten Probenvolumen 24. Das Shimsystem 60 besteht hier aus einem Satz von normalleitenden, elektrischen Magnetspulen, die an der Innenseite der Wand der RT-Bohrung 14 axial beiderseits des zweiten Probenvolumens 24 angeordnet sind.

In der gezeigten Bauform kann der Zusatzspulenbehälter 21 zusammen mit dem Zusatzvakuumbehälter 25 besonders einfach montiert oder ausgetauscht werden, oder auch gegenüber dem Kryostaten 2 ausgerichtet werden. Zudem ist durch die Trennung des Vakuums 5 in der RT-Ummantelung 4 und des Vakuums 23 im Zusatzvakuumbehälter 25 eine sehr gute thermische Isolierung von Hauptspulenbehälter 6 und Zusatzspulenbehälter 21 gegeben.

Die **Fig. 4** zeigt eine vierte Ausführungsform eines erfindungsgemäßen Magnetsystems 1. Der Zusatzspulenbehälter 21 ist hier wiederum in einem Zusatzvakuumbehälter 25 angeordnet, der ein Vakuum 23 für den Zusatzspulenbehälter 21 zur Verfügung stellt.

Der Zusatzvakuumbehälter 25 und die Flanschöffnung 19 werden hier vom Haubenabschnitt 18 übergriffen, der gegenüber der RT-Ummantelung 4 nach außen (hier nach axial oben hin) übersteht. Ein evakuierter zweiter Spaltraum 31 zwischen dem Haubenabschnitt 18 und der Zusatzvakuumbehälter 25 ist hier zur RT-Ummantelung 4 (in Fig. 4 nach unten hin, auf die Flanschöffnung 19 zu) offen ausgebildet, so dass in dem zweiten Spaltraum 31 das gleiche Vakuum 5 wie im Inneren der RT-Ummantelung 4 des Kryostaten 2 herrscht. Mit anderen Worten, der Zusatzvakuumbehälter 25 ist selbst im Vakuum 5 angeordnet, wobei das Vakuum 5 der RT-Ummantelung 4 und das Vakuum 23, in welchem der Zusatzspulenbehälter 21 angeordnet sind, durch die Wand des Zusatzvakuumbehälters 25 getrennt (gegeneinander abgedichtet) sind. Falls gewünscht, kann der Zusatzvakuumbehälter 25 zusätzlich gekühlt werden, beispielsweise mit flüssigem Stickstoff (nicht näher dargestellt). In einer nicht näher gezeigten Variante kann zudem der Zusatzvakuumbehälter 25 auch durch einen nicht gasdichten, gekühlten Zusatzzwischenbehälter als Strahlungsschild ersetzt werden.

Der Zusatzvakuumbehälter 25 ragt mit einem hinteren (oberen) Ende in den Haubenabschnitt 18 hinein, und mit einem vorderen (unteren) Ende durch die Flanschöffnung 19 in die RT-Ummantelung 4 hinein. Entsprechendes gilt auch für den Zusatzspulenbehälter 21 und den Zusatzfeldmagneten 22. Der Haubenabschnitt 18 dichtet die RT-Ummantelung 4 (bzw. das Vakuum 5 in ihrem Inneren) zwischen dem Flanschanschluss 17 und der RT-Bohrung 14 gegenüber der Umgebung 3 ab. Die RT-Bohrung 14 wird hier durch ein durchgängiges (einstückiges) Wandrohr 15 begrenzt.

In der Bauform von Fig. 4 wird eine bestmögliche thermische Isolation des Zusatzspulenbehälters 21 vom Hauptspulenbehälter 6 erreicht. Eine Quenchgefahr für den Hauptfeldmagneten 7 im Falle eines Energieeintrags in den Zusatzspulenbehälter 21, beispielsweise durch Sweepen des zweiten Magnetfelds im zweiten Probenvolumen 24, ist minimiert.

Die Figuren 5a-5g illustrieren eine erste Variante eines erfindungsgemäßen Verfahrens zur Nachrüstung eines Standard-NMR-Magnetsystems auf ein erfindungsgemäßes Magnetsystem; das erhaltene, erfindungsgemäße Magnetsystem entspricht hier der in Fig. 1 gezeigten Ausführungsform.

In einem ersten Schritt a) wird zunächst ein herkömmliches Magnetsystem 50 bereitgestellt, das für NMR-Experimente mit nur einem Magnetfeld bzw. Probenvolumen eingesetzt wird, wie in **Fig. 5a** gezeigt ("Standard-NMR-System"). Das Magnetsystems 50 verfügt über einen Kryostaten 2 mit einer RT-Ummantelung 4, in welcher ein Hauptfeldmagnet 7 in einem gekühlten Hauptspulenbehälter 6 angeordnet ist. Der Kryostat 2 verfügt hier über eine vertikale RT-Bohrung 14, in welcher an einem ersten Probenvolumen 16 ein erstes Magnetfeld mit dem Hauptfeldmagneten 7 erzeugbar ist. Die RT-Bohrung 14 wird durch ein vorhandenes, einteiliges Wandrohr 52 begrenzt. Der Kryostat 2 ist hier an seinem oberen axialen Ende, vgl. Achse A, über einen Flanschanschluss 17 zugänglich, der mit einem Flanschdeckel 51 verschlossen ist, um im herkömmlichen Betrieb des Magnetsystems 50 in der RT-Ummantelung 4 ein Vakuum 5 halten zu können.

In einem nächstens Schritt b) wird nun der Flanschdeckel 51 vom Flanschanschluss 17 entfernt, vgl. **Fig. 5b****.** Nötigenfalls wird dafür zunächst das Innere der RT-Ummantelung 4 belüftet. In der gezeigten Variante wird in diesem Schritt auch das vorhandene Wandrohr 52 entfernt.

Die **Fig. 5c** zeigt das solchermaßen geöffnete Magnetsystem 50. Der offenstehende Flanschanschluss 17 besitzt eine (runde) Flanschöffnung 19 mit einem minimalen Innendurchmesser MID. Der minimale Innendurchmesser MID wird dabei quer zur RT-Bohrung 14 bzw. senkrecht zur Achse A gemessen (gilt auch für alle weiteren Durchmesser, siehe unten).

Sodann wird in einem Schritt c) die Montage eines Zusatzspulenbehälters 21 und einer Verschlussstruktur 20, hier ausgebildet mit einem Haubenabschnitt 18, vorgenommen, vgl. **Fig. 5d****.** Der Zusatzspulenbehälter 21 und die Verschlussstruktur 20 sind in nicht näher dargestellter Weise miteinander fest verbunden und bilden daher eine als Ganzes montierbare Baugruppe 53 aus. Der Zusatzspulenbehälter 21 hat (zumindest soweit er axial in die Flanschöffnung 19 eingreifen soll) einen maximalen Durchmesser DZSB. Da die Baugruppe 53 hier außer dem Zusatzspulenbehälter 21 keine weiteren für den Eingriff in die RT-Ummantelung 4 vorgesehenen Bauteile umfasst, die quer zur Achse A weiter seitlich ausgreifen würden als der Zusatzspulenbehälter 21, ist ein maximaler Außendurchmesser DALL aller durch die Flanschöffnung 19 einzuführenden Teile gleich DZSB, also DALL=DZSB.

Da hier DSZB kleiner als MID ist, kann die Baugruppe 53 beim Montieren einfach in axialer Richtung (hier nach unten) mit ihrem unteren Ende in die Flanschöffnung 19 eingeführt und auf den Flanschanschluss 17 aufgesetzt werden; **Fig. 5e** zeigt den montierten Zustand der Baugruppe 53 auf dem Flanschanschluss 17.

Sodann wird ein neues, einteiliges Wandrohr 54 in das Magnetsystem 50 eingesetzt, vgl. **Fig. 5f****.** Dieses neue Wandrohr 54 ist länger als das zuvor ausgebaute Wandrohr (Bzz. 52 in Fig. 5b).

Nach Montage des neuen Wandrohrs 54 ist die Nachrüstung des Magnetsystems auf einen 2-Feld-NMR-Betrieb abgeschlossen; die **Fig. 5g** zeigt das nachgerüstete, erfindungsgemäße Magnetsystem 1. Insbesondere kann nun mit dem Zusatzfeldmagneten 22 an einem zweiten Probenvolumen 24 in der RT-Bohrung 14 ein zweites Magnetfeld eingerichtet werden. Das neue Wandrohr 54 ist so lang, dass es die RT-Bohrung 14 des Magnetsystems 1 durchgängig vom Bereich des Hauptfeldmagneten 7 bzw. dem unteren Ende des Kryostaten 2 bis zum Zusatzfeldmagneten 22 bzw. dem oberen Ende des Haubenabschnitts 18 ausbildet.

Die Figuren 6a-6g illustrieren eine zweite Variante eines erfindungsgemäßen Verfahrens zur Nachrüstung eines Standard-NMR-Magnetsystems auf ein erfindungsgemäßes Magnetsystem; das erhaltene, erfindungsgemäße Magnetsystem entspricht hier der in Fig. 3 gezeigten Ausführungsform. Die zweite Verfahrensvariante von Fig. 6a-6g ähnelt der ersten Variante von Fig. 5a-5g, so dass nur die wesentlichen Unterschiede näher erläutert werden.

In einem ersten Schritt wird wie in Fig. 5a erläutert ein herkömmliches Magnetsystem 50, das für NMR-Experimente mit nur einem Magnetfeld bzw. Probenvolumen eingerichtet ist, bereitgestellt, vgl. **Fig. 6a****.** Sodann werden in einem Schritt b), wie bereits in Fig. 5b erläutert, der Flanschdeckel 51 und das vorhandene, einstückige Wandrohr 52 der RT-Bohrung entfernt, vgl. **Fig. 6b****.** Dadurch wird der Kryostat 2 mit geöffnetem Flanschanschluss 17 erhalten, wie bereits in Fig. 5c erläutert und in **Fig. 6c** gezeigt. Die (runde) Flanschöffnung 19 weist wiederum einen (maximalen) Innendurchmesser MID auf.

Im Rahmen des nachfolgenden Schritts c) werden nun in beliebiger Reihenfolge ein Einsetzabschnitt 26 am Flanschanschluss 17 montiert und ein neues Wandrohr 55 in den Kryostaten 2 eingesetzt, vgl. **Fig. 6d****.** Dieses neue Wandrohr 55 ist kürzer ausgebildet als das ausgebaute Wandrohr (Bzz. 52 in Fig. 6b). Das neue Wandrohr 55 kann ein Ersatzteil sein, oder auch durch Kürzen des ausgebauten Wandrohrs erhalten worden sein. Der topfförmige Einsetzabschnitt 26 besitzt in seinem Boden einen Durchbruch 26a für die RT-Bohrung. Der Einsetzabschnitt 26 ist das quer zur Achse A größte Bauteil, das in die Flanschöffnung 19 eingeschoben werden muss, und definiert daher einen maximalen Außendurchmesser DALL aller solchermaßen einzuführender Bauteile. Da DALL kleiner ist als MID, kann der Einsetzabschnitt 26 einfach axial in die Flanschöffnung 19 eingeschoben und am Flanschanschluss 17 aufgesetzt und montiert werden.

In **Fig. 6e** kann ersehen werden, dass sich im montierten Zustand das neue Wandrohr 55 vom unteren Ende des Kryostaten 2 bis zum Einsetzabschnitt 26 (im Bereich des Durchbruchs, Bzz. 26 in Fig. 6d) erstreckt. Das Wandrohr 55 bildet ein erstes Teilstück 29 einer Wand einer RT-Bohrung 14 aus.

Anschließend wird eine Baugruppe 56 umfassend einen Zusatzvakuumbehälter 25 und einen darin enthaltenen Zusatzspulenbehälter 21 mit dem Zusatzmagneten 22 montiert, vgl. **Fig. 6f****.** Der maximale Außendurchmesser DZVB des Zusatzvakuumbehälters ist dabei kleiner als der minimale Innendurchmesser IEA des aufnehmenden Bereichs des Einsetzabschnitts 26, so dass die Baugruppe 56 axial in den Einsetzabschnitt 26 eingeschoben werden kann. Man beachte, dass auch DZSB < MID und DZVB < MID ist. Der Zusatzvakuumbehälter 25 und damit auch die Baugruppe 56 umfasst hier auch ein zweites Teilstück 30 einer Wand für die RT-Bohrung 14.

Nach Montage der Baugruppe 56, wie in **Fig. 6g** gezeigt ist, ist die Nachrüstung beendet und das erfindungsgemäße Magnetsystem 1 ist vollständig. Die Teilstücke 29, 30 ergänzen sich zu einer vollständigen Wand oder Begrenzung der RT-Bohrung 14. In der RT-Bohrung 14 kann nun im ersten Probenvolumen 16 mit dem Hauptfeldmagneten 7 ein erstes Magnetfeld, und im zweiten Probenvolumen 24 mit dem Zusatzfeldmagneten 22 ein zweites Magnetfeld erzeugt werden, um 2-Feld-NMR-Experimente durchzuführen.

Man beachte, dass die Montage und Demontage der Baugruppe 56 bzw. des Zusatzvakuumbehälters 25 erfolgen kann, ohne ein Vakuum 5 im Inneren der RT-Ummantelung 4 des Kryostaten 2 zu brechen.

Zusammenfassend betrifft die Erfindung ein Magnetsystem (1) für 2-Feld-NMR-Experimente, umfassend
- einen supraleitenden Hauptfeldmagneten (7) zur Erzeugung eines ersten Magnetfelds in einem ersten Probenvolumen (16),
- einen supraleitenden Zusatzfeldmagneten (22) zur Erzeugung eines zweiten Magnetfelds in einem zweiten Probenvolumen (24), und
- einen Kryostaten (2) mit einem gekühlten Hauptspulenbehälter (6), mit einer evakuierten Raumtemperatur(=RT)-Ummantelung (4), und mit einer Raumtemperatur(=RT)-Bohrung (14), die durch den Hauptfeldmagneten (7) und durch den Zusatzfeldmagneten (22) verläuft, dadurch gekennzeichnet,

dass das Magnetsystem (1) einen gekühlten Zusatzspulenbehälter (21) in einem Vakuum (23) umfasst,
dass die RT-Ummantelung (4) einen Flanschanschluss (17) mit einer Flanschöffnung (19) aufweist, durch die die RT-Bohrung (14) verläuft,
dass der Zusatzspulenbehälter (21) mit einem vorderen Ende durch die Flanschöffnung (19) in die RT-Ummantelung (4) hinein ragt, so dass auch der Zusatzfeldmagnet (22) zumindest teilweise durch die Flanschöffnung (19) in die RT-Ummantelung (4) ragt,
und dass eine Verschlussstruktur (20) am Flanschanschluss (17) montiert ist,
welche die RT-Ummantelung (4) zwischen Flanschanschluss (17) und RT-Bohrung (14) abdichtet. Dadurch wird auf kostengünstige Weise eine flexibel einsetzbare 2-Feld-NMR-Spektroskopie mit guter Signalstärke ermöglicht.

### Bezuaszeichenliste

- 1: Magnetsystem
- 2: Kryostat
- 3: Umgebung
- 4: RT-Ummantelung
- 5: Vakuum (in RT-Ummantelung)
- 6: Hauptspulenbehälter
- 7: Hauptfeldmagnet
- 8: flüssiges Helium
- 9a: Halsrohr (zum Hauptspulenbehälter)
- 9b: Halsrohr (zum Hauptspulenbehälter)
- 10: Zwischenbehälter
- 11: Tank für flüssigen Stickstoff
- 12: flüssiger Stickstoff
- 13a: Halsrohr (zum Stickstofftank)
- 13b: Halsrohr (zum Stickstofftank)
- 14: RT-Bohrung
- 15: Wandrohr
- 16: erstes Probenvolumen
- 17: Flanschanschluss
- 18: Haubenabschnitt
- 19: Flanschöffnung
- 20: Verschlussstruktur
- 21: Zusatzspulenbehälter
- 22: Zusatzfeldmagnet
- 23: Vakuum (für Zusatzspulenbehälter)
- 24: zweites Probenvolumen
- 25: Zusatzvakuumbehälter
- 26: Einsetzabschnitt
- 26a: Durchbruch
- 27: Behälterwand
- 28: erster Spaltraum
- 29: erstes Teilstück der Wand der RT-Bohrung (im Kryostaten)
- 30: zweites Teilstück der Wand der RT-Bohrung (im Zusatzvakuumbehälter)
- 31: zweiter Spaltraum
- 50: (herkömmliches, nachzurüstendes) Magnetsystem
- 51: Flanschdeckel
- 52: (vorhandenes) Wandrohr
- 53: Baugruppe
- 54: (längeres, neues) Wandrohr
- 55: (kürzeres, neues) Wandrohr
- 56: Baugruppe
- 60: Shimsystem
- 61: magnetischer Tunnel
- A: Achse
- AB: Abstand von erstem und zweitem Probenvolumen
- DALL: maximaler Durchmesser aller einragenden Bauteile
- DZSB: maximaler Durchmesser des Zusatzspulenbehälters
- DZVB: maximaler Durchmesser des Zusatzvakuumbehälters
- IEA: minimaler Innendurchmesser des Einsetzabschnitts
- MID: maximaler Innendurchmesser (Flanschöffnung)

## Patentansprüche

1. Magnetsystem (1) zur Durchführung von 2-Feld-NMR-Experimenten, umfassend
- einen supraleitenden Hauptfeldmagneten (7), geeignet zur Erzeugung eines ersten Magnetfelds in einem ersten Probenvolumen (16),
- einen supraleitenden Zusatzfeldmagneten (22), geeignet zur Erzeugung eines zweiten Magnetfelds in einem zweiten Probenvolumen (24), wobei das erste Magnetfeld stärker ist als das zweite Magnetfeld, und
- einen Kryostaten (2) mit einem gekühlten Hauptspulenbehälter (6), der den Hauptfeldmagneten (7) enthält, mit einer evakuierten Raumtemperatur(=RT)-Ummantelung (4), die den Hauptspulenbehälter (6) enthält, und mit einer Raumtemperatur(=RT)-Bohrung (14), die durch den Hauptfeldmagneten (7) und durch den Zusatzfeldmagneten (22) verläuft und das erste Probenvolumen (16) und das zweite Probenvolumen (24) enthält,
**dadurch gekennzeichnet,**
**dass** das Magnetsystem (1) einen gekühlten Zusatzspulenbehälter (21) umfasst, der von einem Vakuum (23) umgeben ist, der den Zusatzfeldmagneten (22) enthält und der vom Hauptspulenbehälter (6) beabstandet ist,
**dass** die RT-Ummantelung (4) einen Flanschanschluss (17) aufweist, wobei die RT-Bohrung (14) durch eine Flanschöffnung (19) des Flanschanschlusses (17) verläuft,
**dass** der Zusatzspulenbehälter (21) mit einem vorderen Ende durch die Flanschöffnung (19) in die RT-Ummantelung (4) hinein ragt, so dass auch der Zusatzfeldmagnet (22) zumindest teilweise durch die Flanschöffnung (19) in die RT-Ummantelung (4) ragt,
und **dass** eine Verschlussstruktur (20) vorhanden ist, welche am Flanschanschluss (17) der RT-Ummantelung (4) montiert ist, und welche die RT-Ummantelung (4) zwischen Flanschanschluss (17) und RT-Bohrung (14) abdichtet.

2. Magnetsystem (1) nach Anspruch 1, **dadurch gekennzeichnet, dass** das Magnetsystem (1) einen geschlossenen, evakuierten Zusatzvakuumbehälter (25) ausbildet, in welchem der Zusatzspulenbehälter (21) angeordnet ist, und in welchem das Vakuum (23) herrscht, in dem der Zusatzspulenbehälter (21) angeordnet ist, so dass das Vakuum (23) im Zusatzvakuumbehälter (25) getrennt ist von einem Vakuum (5) in der RT-Ummantelung (4).

3. Magnetsystem (1) nach einem der vorhergehenden Ansprüche, **dadurch gekennzeichnet, dass** die Verschlussstruktur (20) einen Einsetzabschnitt (26) umfasst, welcher in die Flanschöffnung (19) einragt und welcher gegenüber der RT-Ummantelung (4) nach innen übersteht,
dass der Zusatzspulenbehälter (21) mit einem vorderen Ende in den Einsetzabschnitt (26) hinein ragt,
und dass die RT-Bohrung (14) durch den Einsetzabschnitt (26) verläuft.

4. Magnetsystem (1) nach einem der vorhergehenden Ansprüche, **dadurch gekennzeichnet,**
**dass** das Magnetsystem (1) einen Haubenabschnitt (18) umfasst, welcher die Flanschöffnung (19) übergreift und welcher gegenüber der RT-Ummantelung (4) nach außen übersteht,
**dass** der Zusatzspulenbehälter (21) mit einem hinteren Ende in den Haubenabschnitt (18) hinein ragt,
und **dass** die RT-Bohrung (14) durch den Haubenabschnitt (18) verläuft.

5. Magnetsystem nach den Ansprüchen 2, 3 und 4, **dadurch gekennzeichnet, dass** der Zusatzvakuumbehälter (25) durch die Wände des Haubenabschnitts (18), des Einsetzabschnitts (26) und der RT-Bohrung (14) begrenzt wird, wobei der Einsetzabschnitt (26) das Vakuum (5) in der RT-Ummantelung (4) gegenüber dem Vakuum (23) im Zusatzvakuumbehälter (25) abdichtet.

6. Magnetsystem nach Anspruch 4, **dadurch gekennzeichnet,**
**dass** die Verschlussstruktur (20) den Haubenabschnitt (18) umfasst,
**dass** ein erster Spaltraum (28) zwischen den Wänden des Zusatzspulenbehälters (21) und des Haubenabschnitts (18) zur RT-Ummantelung (4) hin offen ausgebildet ist,
**dass** das Vakuum (23), in dem der Zusatzspulenbehälter (21) angeordnet ist, und ein Vakuum (5) in der RT-Ummantelung (4) miteinander verbunden sind,
und **dass** der Haubenabschnitt (18) das Vakuum (5) in der RT-Ummantelung (4) gegenüber der Umgebung (3) abdichtet.

7. Magnetsystem nach Anspruch 2 und 4, **dadurch gekennzeichnet,**
**dass** die Verschlussstruktur (20) den Haubenabschnitt (18) umfasst,
**dass** der Zusatzvakuumbehälter (25) mit einem hinteren Ende in den Haubenabschnitt (18) hineinragt,
**dass** ein zweiter Spaltraum (31) zwischen den Wänden des Haubenabschnitts (18) und des Zusatzvakuumbehälters (25) zur RT-Ummantelung (4) hin offen ausgebildet ist,
und **dass** der Haubenabschnitt (18) das Vakuum (5) in der RT-Ummantelung (4) gegenüber der Umgebung (3) abdichtet.

8. Magnetsystem nach den Ansprüchen 2 und 3, **dadurch gekennzeichnet, dass** der Zusatzvakuumbehälter (25) auf einer dem Hauptspulenbehälter (6) abgewandten Seite des Einsetzabschnitts (26) angeordnet ist, dass der Zusatzvakuumbehälter (25) durch eine vom Einsetzabschnitt (26) separate Behälterwand (27) und die RT-Bohrung (14) begrenzt wird, und dass der Einsetzabschnitt (26) das Vakuum (5) in der RT-Ummantelung (4) gegenüber der Umgebung (3) abdichtet.

9. Magnetsystem (1) nach Anspruch 8, **dadurch gekennzeichnet, dass** die Wand der RT-Bohrung (14) mehrteilig ausgebildet ist, wobei ein erstes Teilstück (29) der Wand der RT-Bohrung (14) die RT-Ummantelung (4) bis zum Einsetzabschnitt (26) begrenzt, und wobei ein zweites Teilstück (30) der Wand der RT-Bohrung (14) den Zusatzvakuumbehälter (25) begrenzt.

10. Magnetsystem (1) nach einem der Ansprüche 1 bis 8, **dadurch gekennzeichnet, dass** die Wand der RT-Bohrung (14) einteilig ausgebildet ist.

11. Magnetsystem (1) nach einem der vorhergehenden Ansprüche, **dadurch gekennzeichnet, dass** der Kryostat (2) mit einem gekühlten Zwischenbehälter (10) ausgebildet ist, der in der evakuierten RT-Ummantelung (4) angeordnet ist, wobei der Hauptspulenbehälter (6) im Zwischenbehälter (10) angeordnet ist,
insbesondere wobei der Zwischenbehälter (10) mit flüssigem Stickstoff gekühlt ist.

12. Magnetsystem (1) nach einem der vorhergehenden Ansprüche, **dadurch gekennzeichnet, dass** der Zusatzspulenbehälter (21) einen maximalen Außendurchmesser DZSB quer zur RT-Bohrung (14) aufweist, der kleiner ist als der minimale Innendurchmesser MID der Flanschöffnung (19), insbesondere wobei alle durch die Flanschöffnung (19) in die RT-Ummantelung (4) einragenden Bauteile einen maximalen Außendurchmesser DALL quer zur RT-Bohrung (14) aufweisen, der kleiner ist als der minimale Innendurchmesser MID der Flanschöffnung (19).

13. Magnetsystem (1) nach einem der vorhergehenden Ansprüche, **dadurch gekennzeichnet, dass** ein Shimsystem (60) zur Homogenisierung des Magnetfelds im zweiten Probenvolumen (24) vorhanden ist.

14. Magnetsystem (1) nach einem der vorhergehenden Ansprüche, **dadurch gekennzeichnet, dass** die RT-Bohrung (14) in einem Bereich zwischen dem ersten Probenvolumen (16) und dem zweiten Probenvolumen (24) durch einen magnetischen Tunnel (61) führt oder einen magnetischen Tunnel (61) enthält, sodass im Betrieb das Magnetfeld entlang eines Probentransportwegs in der RT-Bohrung (14) zwischen dem ersten Probenvolumen (16) und dem zweiten Probenvolumen (24) überall wenigstens 0,1 T, bevorzugt wenigstens 0,5 T, beträgt.

15. Magnetsystem (1) nach einem der vorhergehenden Ansprüche, **dadurch gekennzeichnet, dass** das erste Probenvolumen (16) und das zweite Probenvolumen (24) einen Abstand AB aufweisen,
mit 0,6 m ≤ AB ≤ 1,3 m.

16. Magnetsystem (1) nach einem der vorhergehenden Ansprüche, **dadurch gekennzeichnet, dass** der Hauptfeldmagnet (7) und der Zusatzfeldmagnet (22) elektrisch voneinander getrennt sind.

17. Verfahren zur Nachrüstung eines Magnetsystems (50) für 2-Feld-NMR-Experimente, insbesondere um ein Magnetsystem (1) nach einem der vorhergehenden Ansprüche zu erhalten, mit folgenden Schritten:
a) Bereitstellen eines Magnetsystems (50) umfassend einen supraleitenden Hauptfeldmagneten (7), geeignet zur Erzeugung eines ersten Magnetfelds in einem ersten Probenvolumen (16), und einen Kryostaten (2) mit einem kühlbaren Hauptspulenbehälter (6), der den Hauptfeldmagneten (7) enthält, mit einer evakuierbaren Raumtemperatur(=RT)-Ummantelung (4), die den Hauptspulenbehälter (6) enthält, und mit einer Raumtemperatur(=RT)-Bohrung (14), die durch den Hauptfeldmagneten (7) verläuft und das erste Probenvolumen (16) enthält, wobei die RT-Ummantelung (4) einen Flanschanschluss (17) aufweist, dessen Flanschöffnung (19) mit einem Flanschdeckel (51) verschlossen ist, wobei die RT-Bohrung (14) durch die Flanschöffnung (19) und den Flanschdeckel (51) verläuft;
b) Entfernen des Flanschdeckels (51) vom Flanschanschluss (17);
c) Montieren eines Zusatzspulenbehälters (21), der im montierten Zustand kühlbar und mit einem Vakuum (23) umgebbar ist, und der einen supraleitenden Zusatzfeldmagneten (22) enthält,
und Montieren einer Verschlussstruktur (20), welche die RT-Ummantelung (4) zwischen Flanschanschluss (17) und RT-Bohrung (4) abdichtet, am Flanschanschluss (17) der RT-Ummantelung (4),
wobei der Zusatzspulenbehälter (21) mit einem vorderen Ende durch die Flanschöffnung (19) in die RT-Ummantelung (4) hinein ragt, so dass der Zusatzfeldmagnet (22) zumindest teilweise durch die Flanschöffnung (19) in die RT-Ummantelung (4) ragt,
wobei der Zusatzfeldmagnet (22) geeignet ist zur Erzeugung eines zweiten Magnetfelds in einem zweiten Probenvolumen (24), wobei das erste Magnetfeld stärker ist als das zweite Magnetfeld, und wobei die RT-Bohrung (14) auch durch den Zusatzfeldmagneten (22) verläuft und das zweite Probenvolumen (24) enthält.

18. Verfahren nach Anspruch 17, **dadurch gekennzeichnet, dass** während Schritt c) der Zusatzspulenbehälter (21) fest mit der Verschlussstruktur (20) verbunden ist,
insbesondere wobei während Schritt c) alle durch die Flanschöffnung (19) in die RT-Ummantelung (4) einragenden Bauteile fest mit der Verschlussstruktur (20) verbunden sind.

19. Verfahren nach Anspruch 17 oder 18, **dadurch gekennzeichnet, dass** nach Schritt a) ein vorhandenes, einteiliges Wandrohr (52) der RT-Bohrung (14) des Kryostaten (2) durch ein axial längeres, einteiliges Wandrohr (54) ersetzt wird.

20. Verfahren nach Anspruch 17 oder 18, **dadurch gekennzeichnet, dass** nach Schritt a) ein vorhandenes, einteiliges Wandrohr (52) der RT-Bohrung (14) des Kryostaten (2) gekürzt oder durch ein kürzeres Wandrohr (55) ersetzt wird, so dass im Kryostaten (2) ein erstes Teilstück (29) einer Wand der RT-Bohrung (14) angeordnet ist, welches zumindest den Hauptspulenbehälter (6) durchragt, und weiterhin ein zweites Teilstück (30) einer Wand der RT-Bohrung (14) montiert wird, welches zumindest den Zusatzspulenbehälter (21) durchragt,
insbesondere wobei das zweite Teilstück (30) während Schritt c) zusammen mit dem Zusatzspulenbehälter (21) montiert wird.

## Claims

1. Magnet system (1) for performing 2-field NMR experiments, comprising
- a superconducting main field magnet (7) suitable for generating a first magnetic field in a first sample volume (16),
- a superconducting additional field magnet (22) suitable for generating a second magnetic field in a second sample volume (24), the first magnetic field being stronger than the second magnetic field, and
- a cryostat (2) having a cooled main coil container (6) which contains the main field magnet (7), having an evacuated room temperature (= RT) covering (4) which contains the main coil container (6), and having a room temperature (= RT) bore (14) which extends through the main field magnet (7) and through the additional field magnet (22) and contains the first sample volume (16) and the second sample volume (24),
**characterized**
**in that** the magnet system (1) comprises a cooled additional coil container (21) which is surrounded by a vacuum (23), contains the additional field magnet (22) and is spaced apart from the main coil container (6),
**in that** the RT covering (4) has a flange connection (17), the RT bore (14) extending through a flange opening (19) of the flange connection (17),
**in that** a front end of the additional coil container (21) protrudes through the flange opening (19) into the RT covering (4) such that the additional field magnet (22) also at least partly protrudes through the flange opening (19) into the RT covering (4),
and **in that** there is a closure structure (20) which is installed on the flange connection (17) of the RT covering (4) and seals the RT covering (4) between the flange connection (17) and the RT bore (14).

2. Magnet system (1) according to claim 1, **characterized in that** the magnet system (1) forms a closed, evacuated additional vacuum container (25) in which the additional coil container (21) is arranged, and in which the vacuum (23) in which the additional coil container (21) is arranged prevails such that the vacuum (23) in the additional vacuum container (25) is separated from a vacuum (5) in the RT covering (4).

3. Magnet system (1) according to either of the preceding claims, **characterized**
**in that** the closure structure (20) comprises an insert portion (26) which protrudes into the flange opening (19) and projects inwardly with respect to the RT covering (4),
**in that** a front end of the additional coil container (21) protrudes into the insert portion (26),
and **in that** the RT bore (14) extends through the insert portion (26).

4. Magnet system (1) according to any of the preceding claims, **characterized in that** the magnet system (1) comprises a hood portion (18) which engages over the flange opening (19) and projects outwardly with respect to the RT covering (4),
**in that** a rear end of the additional coil container (21) protrudes into the hood portion (18),
and **in that** the RT bore (14) extends through the hood portion (18).

5. Magnet system according to claims 2, 3 and 4, **characterized in that** the additional vacuum container (25) is delimited by the walls of the hood portion (18), of the insert portion (26) and of the RT bore (14), the insert portion (26) sealing the vacuum (5) in the RT covering (4) from the vacuum (23) in the additional vacuum container (25).

6. Magnet system according to claim 4, **characterized**
**in that** the closure structure (20) comprises the hood portion (18),
**in that** a first gap (28) between the walls of the additional coil container (21) and of the hood portion (18) is designed to be open toward the RT covering (4),
**in that** the vacuum (23) in which the additional coil container (21) is arranged and a vacuum (5) in the RT covering (4) are connected to one another,
and **in that** the hood portion (18) seals the vacuum (5) in the RT covering (4) from the surroundings (3).

7. Magnet system according to claims 2 and 4, **characterized**
**in that** the closure structure (20) comprises the hood portion (18),
**in that** a rear end of the additional vacuum container (25) protrudes into the hood portion (18),
**in that** a second gap (31) between the walls of the hood portion (18) and of the additional vacuum container (25) is designed to be open toward the RT covering (4),
and **in that** the hood portion (18) seals the vacuum (5) in the RT covering (4) from the surroundings (3).

8. Magnet system according to claims 2 and 3, **characterized**
**in that** the additional vacuum container (25) is arranged on a side of the insert portion (26) facing away from the main coil container (6),
**in that** the additional vacuum container (25) is delimited by a container wall (27), which is separate from the insert portion (26), and the RT bore (14),
and **in that** the insert portion (26) seals the vacuum (5) in the RT covering (4) from the surroundings (3).

9. Magnet system (1) according to claim 8, **characterized in that** the wall of the RT bore (14) is formed from multiple pieces, a first section (29) of the wall of the RT bore (14) delimiting the RT covering (4) as far as the insert portion (26), and a second section (30) of the wall of the RT bore (14) delimiting the additional vacuum container (25).

10. Magnet system (1) according to any of claims 1 to 8, **characterized in that** the wall of the RT bore (14) is formed in one piece.

11. Magnet system (1) according to any of the preceding claims, **characterized in that** the cryostat (2) is designed having a cooled intermediate container (10) which is arranged in the evacuated RT covering (4), the main coil container (6) being arranged in the intermediate container (10),
in particular the intermediate container (10) being cooled with liquid nitrogen.

12. Magnet system (1) according to any of the preceding claims, **characterized in that** the additional coil container (21) has a maximum outer diameter DZSB transverse to the RT bore (14) that is smaller than the minimum inner diameter MID of the flange opening (19),
in particular all components which protrude through the flange opening (19) into the RT covering (4) having a maximum outer diameter DALL transverse to the RT bore (14) that is smaller than the minimum inner diameter MID of the flange opening (19).

13. Magnet system (1) according to any of the preceding claims, **characterized in that** there is a shim system (60) for homogenizing the magnetic field in the second sample volume (24).

14. Magnet system (1) according to any of the preceding claims, **characterized in that** the RT bore (14) passes through a magnetic tunnel (61) in a region between the first sample volume (16) and the second sample volume (24) or contains a magnetic tunnel (61) such that during operation the magnetic field is at least 0.1 T, preferably at least 0.5 T, everywhere along a sample transport path in the RT bore (14) between the first sample volume (16) and the second sample volume (24).

15. Magnet system (1) according to any of the preceding claims, **characterized in that** the first sample volume (16) and the second sample volume (24) are at a distance AB,
where 0.6 m ≤ AB ≤ 1.3 m.

16. Magnet system (1) according to any of the preceding claims, **characterized in that** the main field magnet (7) and the additional field magnet (22) are electrically separated from one another.

17. Method for retrofitting a magnet system (50) for 2-field NMR experiments, in particular in order to obtain a magnet system (1) according to any of the preceding claims, comprising the following steps:
a) providing a magnet system (50), comprising a superconducting main field magnet (7) suitable for generating a first magnetic field in a first sample volume (16), and a cryostat (2) having a coolable main coil container (6) which contains the main field magnet (7), having an evacuable room temperature (= RT) covering (4) which contains the main coil container (6), and having a room temperature (= RT) bore (14) which extends through the main field magnet (7) and contains the first sample volume (16), the RT covering (4) having a flange connection (17), the flange opening (19) of which is closed by a flange cover (51), the RT bore (14) extending through the flange opening (19) and the flange cover (51);
b) removing the flange cover (51) from the flange connection (17);
c) installing an additional coil container (21) which is coolable in the installed state, is surroundable by a vacuum (23), and contains a superconducting additional field magnet (22),
and installing a closure structure (20) which seals the RT covering (4) between the flange connection (17) and the RT bore (4) on the flange connection (17) of the RT covering (4),
a front end of the additional coil container (21) protruding through the flange opening (19) into the RT covering (4) such that the additional field magnet (22) at least partly protrudes through the flange opening (19) into the RT covering (4),
the additional field magnet (22) being suitable for generating a second magnetic field in a second sample volume (24), the first magnetic field being stronger than the second magnetic field, and the RT bore (14) also extending through the additional field magnet (22) and containing the second sample volume (24).

18. Method according to claim 17, **characterized in that** during step c) the additional coil container (21) is rigidly connected to the closure structure (20),
in particular during step c) all components which protrude through the flange opening (19) into the RT covering (4) being rigidly connected to the closure structure (20).

19. Method according to either claim 17 or claim 18, **characterized in that** after step a) an existing, one-piece wall pipe (52) of the RT bore (14) of the cryostat (2) is replaced by an axially longer, one-piece wall pipe (54).

20. Method according to either claim 17 or claim 18, **characterized in that** after step a) an existing, one-piece wall pipe (52) of the RT bore (14) of the cryostat (2) is shortened or replaced by a shorter wall pipe (55) such that a first section (29) of a wall of the RT bore (14) is arranged in the cryostat (2), which first section protrudes through at least the main coil container (6), and a second section (30) of a wall of the RT bore (14) is also installed, which second section protrudes through at least the additional coil container (21),
in particular the second section (30) being installed together with the additional coil container (21) during step c).

## Revendications

1. Système magnétique (1) pour la réalisation d'expériences de RMN à 2 champs, comprenant
- un aimant de champ principal supraconducteur (7), approprié pour produire un premier champ magnétique dans un premier volume d'échantillon (16),
- un aimant de champ auxiliaire supraconducteur (22), approprié pour produire un deuxième champ magnétique dans un deuxième volume d'échantillon (24), le premier champ magnétique étant plus fort que le deuxième champ magnétique, et
- un cryostat (2) avec un réservoir de bobine principale refroidi (6), qui contient l'aimant de champ principal (7), avec une enveloppe à température ambiante (= RT) évacuée (4) qui contient le réservoir de bobine principale (6), et avec un alésage à température ambiante (= RT) (14) qui s'étend à travers l'aimant de champ principal (7) et à travers l'aimant de champ auxiliaire (22) et qui contient le premier volume d'échantillon (16) et le deuxième volume d'échantillon (24),
**caractérisé**
**en ce que** le système magnétique (1) comprend un réservoir de bobine auxiliaire refroidi (21) qui est entouré par un vide (23), qui contient l'aimant de champ auxiliaire (22) et qui est espacé du réservoir de bobine principale (6),
**en ce que** l'enveloppe RT (4) présente un raccord à bride (17), l'alésage RT (14) s'étendant à travers une ouverture de bride (19) du raccord à bride (17),
**en ce que** le réservoir de bobine auxiliaire (21) fait saillie avec une extrémité avant à travers l'ouverture de bride (19) dans l'enveloppe RT (4), de telle sorte que l'aimant de champ auxiliaire (22) fait également saillie au moins partiellement à travers l'ouverture de bride (19) dans l'enveloppe RT (4),
et **en ce qu'**une structure de fermeture (20) est présente, qui est montée sur le raccord à bride (17) de l'enveloppe RT (4), et qui étanchéifie l'enveloppe RT (4) entre le raccord à bride (17) et l'alésage RT (14).

2. Système magnétique (1) selon la revendication 1, **caractérisé en ce que** le système magnétique (1) réalise un réservoir à vide auxiliaire évacué fermé (25) dans lequel le réservoir de bobine auxiliaire (21) est agencé et dans lequel règne le vide (23) dans lequel le réservoir de bobine auxiliaire (21) est agencé, de telle sorte que le vide (23) dans le réservoir à vide auxiliaire (25) est séparé d'un vide (5) dans l'enveloppe RT (4).

3. Système magnétique (1) selon l'une quelconque des revendications précédentes, **caractérisé en ce que** la structure de fermeture (20) comprend une section d'insertion (26) qui fait saillie dans l'ouverture de bride (19) et qui dépasse vers l'intérieur par rapport à l'enveloppe RT (4),
**en ce que** le réservoir de bobine auxiliaire (21) fait saillie avec une extrémité avant dans la section d'insertion (26),
et **en ce que** l'alésage RT (14) s'étend à travers la section d'insertion (26).

4. Système magnétique (1) selon l'une quelconque des revendications précédentes, **caractérisé**
**en ce que** le système magnétique (1) comprend une section de capot (18) qui recouvre l'ouverture de bride (19) et qui dépasse vers l'extérieur par rapport à l'enveloppe RT (4),
**en ce que** le réservoir de bobine auxiliaire (21) fait saillie avec une extrémité arrière dans la section de capot (18),
et **en ce que** l'alésage RT (14) s'étend à travers la section de capot (18).

5. Système magnétique selon les revendications 2, 3 et 4, **caractérisé en ce que** le réservoir à vide auxiliaire (25) est délimité par les parois de la section de capot (18), de la section d'insertion (26) et de l'alésage RT (14), la section d'insertion (26) étanchéifiant le vide (5) dans l'enveloppe RT (4) par rapport au vide (23) dans le réservoir à vide auxiliaire (25).

6. Système magnétique selon la revendication 4, **caractérisé**
**en ce que** la structure de fermeture (20) comprend la section de capot (18),
**en ce qu'**un premier espace (28) est réalisé ouvert vers l'enveloppe RT (4) entre les parois du réservoir de bobine auxiliaire (21) et la section de capot (18),
**en ce que** le vide (23) dans lequel le réservoir de bobine auxiliaire (21) est agencé et un vide (5) dans l'enveloppe RT (4) sont reliés entre eux,
et **en ce que** la section de capot (18) étanchéifie le vide (5) dans l'enveloppe RT (4) par rapport à l'environnement (3) .

7. Système magnétique selon les revendications 2 et 4, **caractérisé**
**en ce que** la structure de fermeture (20) comprend la section de capot (18),
**en ce que** le réservoir à vide auxiliaire (25) fait saillie avec une extrémité arrière dans la section de capot (18), en ce qu'un deuxième espace (31) est réalisé ouvert vers l'enveloppe RT (4) entre les parois de la section de capot (18) et le réservoir à vide auxiliaire (25),
et **en ce que** la section de capot (18) étanchéifie le vide (5) dans l'enveloppe RT (4) par rapport à l'environnement (3) .

8. Système magnétique selon les revendications 2 et 3, **caractérisé**
**en ce que** le réservoir à vide auxiliaire (25) est agencé sur un côté de la section d'insertion (26) détourné du réservoir de bobine principale (6),
**en ce que** le réservoir à vide auxiliaire (25) est délimité par une paroi de réservoir (27) séparée de la section d'insertion (26) et l'alésage RT (14),
et **en ce que** la section d'insertion (26) étanchéifie le vide (5) dans l'enveloppe RT (4) par rapport à l'environnement (3).

9. Système magnétique (1) selon la revendication 8, **caractérisé en ce que** la paroi de l'alésage RT (14) est réalisée en plusieurs parties, une première pièce partielle (29) de la paroi de l'alésage RT (14) délimitant l'enveloppe RT (4) jusqu'à la section d'insertion (26), et une deuxième pièce partielle (30) de la paroi de l'alésage RT (14) délimitant le réservoir à vide auxiliaire (25).

10. Système magnétique (1) selon l'une quelconque des revendications 1 à 8, **caractérisé en ce que** la paroi de l'alésage RT (14) est réalisée d'une seule pièce.

11. Système magnétique (1) selon l'une quelconque des revendications précédentes, **caractérisé en ce que** le cryostat (2) est réalisé avec un réservoir intermédiaire refroidi (10) qui est agencé dans l'enveloppe RT évacuée (4), le réservoir de bobine principale (6) étant agencé dans le réservoir intermédiaire (10),
en particulier le réservoir intermédiaire (10) étant refroidi avec de l'azote liquide.

12. Système magnétique (1) selon l'une quelconque des revendications précédentes, **caractérisé en ce que** le réservoir de bobine auxiliaire (21) présente un diamètre extérieur maximal DZSB transversalement à l'alésage RT (14) qui est inférieur au diamètre intérieur minimal MID de l'ouverture de bride (19),
en particulier tous les composants faisant saillie dans l'enveloppe RT (4) à travers l'ouverture de bride (19) présentant un diamètre extérieur maximal DALL transversalement à l'alésage RT (14) qui est inférieur au diamètre intérieur minimal MID de l'ouverture de bride (19) .

13. Système magnétique (1) selon l'une quelconque des revendications précédentes, **caractérisé en ce qu'**un système de shim (60) est présent pour homogénéiser le champ magnétique dans le deuxième volume d'échantillon (24) .

14. Système magnétique (1) selon l'une quelconque des revendications précédentes, **caractérisé en ce que** l'alésage RT (14) traverse un tunnel magnétique (61) dans une zone entre le premier volume d'échantillon (16) et le deuxième volume d'échantillon (24) ou contient un tunnel magnétique (61), de telle sorte qu'en fonctionnement, le champ magnétique le long d'un trajet de transport d'échantillon dans l'alésage RT (14) entre le premier volume d'échantillon (16) et le deuxième volume d'échantillon (24) est partout d'au moins 0,1 T, de préférence d'au moins 0,5 T.

15. Système magnétique (1) selon l'une quelconque des revendications précédentes, **caractérisé en ce que** le premier volume d'échantillon (16) et le deuxième volume d'échantillon (24) présentent une distance AB,
avec 0,6 m ≤ AB ≤ 1,3 m.

16. Système magnétique (1) selon l'une quelconque des revendications précédentes, **caractérisé en ce que** l'aimant de champ principal (7) et l'aimant de champ auxiliaire (22) sont électriquement séparés l'un de l'autre.

17. Procédé de mise à niveau d'un système magnétique (50) pour des expériences de RMN à 2 champs, en particulier pour obtenir un système magnétique (1) selon l'une quelconque des revendications précédentes, comprenant les étapes suivantes :
a) la fourniture d'un système magnétique (50) comprenant un aimant de champ principal supraconducteur (7) approprié pour produire un premier champ magnétique dans un premier volume d'échantillon (16), et un cryostat (2) avec un réservoir de bobine principale refroidissable (6), qui contient l'aimant de champ principal (7), avec une enveloppe (4) à température ambiante (= RT) pouvant être évacuée qui contient le réservoir de bobine principale (6), et avec un alésage (14) à température ambiante (= RT) qui s'étend à travers l'aimant de champ principal (7) et qui contient le premier volume d'échantillon (16), l'enveloppe RT (4) présentant un raccord à bride (17) dont l'ouverture de bride (19) est fermée par un couvercle de bride (51), l'alésage RT (14) s'étendant à travers l'ouverture de bride (19) et le couvercle de bride (51) ;
b) le retrait du couvercle de bride (51) du raccord à bride (17) ;
c) le montage d'un réservoir de bobine auxiliaire (21), qui peut être refroidi et entouré par un vide (23) à l'état monté, et qui contient un aimant de champ auxiliaire supraconducteur (22),
et le montage d'une structure de fermeture (20), qui étanchéifie l'enveloppe RT (4) entre le raccord à bride (17) et l'alésage RT (4), sur le raccord à bride (17) de l'enveloppe RT (4),
le réservoir de bobine auxiliaire (21) faisant saillie avec une extrémité avant à travers l'ouverture de bride (19) dans l'enveloppe RT (4), de telle sorte que l'aimant de champ auxiliaire (22) s'étend au moins partiellement à travers l'ouverture de bride (19) dans l'enveloppe RT (4) ,
l'aimant de champ auxiliaire (22) étant approprié pour produire un deuxième champ magnétique dans un deuxième volume d'échantillon (24), le premier champ magnétique étant plus fort que le deuxième champ magnétique, et l'alésage RT (14) s'étendant également à travers l'aimant de champ auxiliaire (22) et contenant le deuxième volume d'échantillon (24).

18. Procédé selon la revendication 17, **caractérisé en ce que**, pendant l'étape c), le réservoir de bobine auxiliaire (21) est relié de manière fixe à la structure de fermeture (20),
en particulier, pendant l'étape c), tous les composants faisant saillie dans l'enveloppe RT (4) à travers l'ouverture de bride (19) étant reliés de manière fixe à la structure de fermeture (20).

19. Procédé selon la revendication 17 ou 18, **caractérisé en ce qu'**après l'étape a), un tube de paroi d'une seule pièce existant (52) de l'alésage RT (14) du cryostat (2) est remplacé par un tube de paroi d'une seule pièce axialement plus long (54).

20. Procédé selon la revendication 17 ou 18, **caractérisé en ce qu'**après l'étape a), un tube de paroi d'une seule pièce existant (52) de l'alésage RT (14) du cryostat (2) est raccourci ou remplacé par un tube de paroi plus court (55), de telle sorte qu'une première pièce partielle (29) d'une paroi de l'alésage RT (14) est agencée dans le cryostat (2), qui fait saillie à travers au moins le réservoir de bobine principale (6), et en outre une deuxième pièce partielle (30) d'une paroi de l'alésage RT (14) est montée, qui fait saillie à travers au moins le réservoir de bobine auxiliaire (21),
en particulier la deuxième pièce partielle (30) étant montée conjointement avec le réservoir de bobine auxiliaire (21) pendant l'étape c).
